(19) Europäisches Patentamt / European Patent Office / Office européen des brevets

(11) **EP 4 206 161 A1**

(12) **EUROPEAN PATENT APPLICATION**

(43) Date of publication:
**05.07.2023 Bulletin 2023/27**

(21) Application number: **22214442.0**

(22) Date of filing: **19.12.2022**

(51) International Patent Classification (IPC):
**C04B 35/495** (2006.01)    **H10N 30/853** (2023.01)

(52) Cooperative Patent Classification (CPC):
**C04B 35/495; H10N 30/8542;** C04B 2235/3201;
C04B 2235/3208; C04B 2235/3213;
C04B 2235/3215; C04B 2235/3244;
C04B 2235/3248; C04B 2235/3251;
C04B 2235/3255; C04B 2235/3272;
C04B 2235/3291; C04B 2235/3294;
C04B 2235/3298; C04B 2235/765;    (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.01.2022 KR 20220000010**

(71) Applicants:
• **LG Display Co., Ltd.**
**SEOUL, 07336 (KR)**
• **Korea University Research and Business
Foundation
Seoul 02841 (KR)**

(72) Inventors:
• **LEE, YongWoo**
**10845 Paju-si (KR)**
• **PARK, SeungRyull**
**10845 Paju-si (KR)**
• **HAM, Yong-Su**
**10845 Paju-si (KR)**
• **KHO, YuSeon**
**10845 Paju-si (KR)**
• **SUNG, Seunghyun**
**10845 Paju-si (KR)**
• **NAHM, Sahn**
**06207 Seoul (KR)**
• **KIM, Dae-Su**
**02497 Seoul (KR)**
• **SHIN, Hosung**
**02475 Seoul (KR)**
• **EUM, Jae Min**
**02576 Seoul (KR)**
• **GO, Su-Hwan**
**02498 Seoul (KR)**

(74) Representative: **Ter Meer Steinmeister & Partner
Patentanwälte mbB
Nymphenburger Straße 4
80335 München (DE)**

(54) **PIEZOELECTRIC MATERIAL COMPOSITION, METHOD OF MANUFACTURING THE SAME, PIEZOELECTRIC DEVICE, AND APPARATUS INCLUDING THE PIEZOELECTRIC DEVICE**

(57) A piezoelectric device may include a piezoelectric device layer including a first material and a second material surrounded by the first material, a first electrode portion disposed at a first surface of the piezoelectric device layer, and a second electrode portion disposed at a second surface of the piezoelectric device layer opposite to the first surface. The piezoelectric device layer is represented by Formula 1 "$0.96(Na_aK_{1-a})(Nb_b(T_{1-b}))O_3 - (0.04-x)MZrO_3 - x(Bi_cAg_{1-c})ZrO_3 (+ d\ mol\%\ NaNbO_3$", wherein T is Sb or Ta, M is Sr, Ba or Ca, $0.4 \le a \le 0.6$, $0.90 \le b \le 0.98$, $0.4 \le c \le 0.6$, $0 \le d \le 5.0$, and $0 \le x \le 0.04$.

**FIG. 1**

S100

S10    S20
WEIGHING — S101
MIXING — S102
MOLDING — S103
SINTERING — S104
FORMING ELECTRODE — S105

(52) Cooperative Patent Classification (CPC): (Cont.)
C04B 2235/768; C04B 2235/781;
C04B 2235/787; C04B 2235/79; C04B 2235/80

**Description**

## BACKGROUND

### Technical Field

The present disclosure relates to a piezoelectric material composition, a method of manufacturing the same, a piezoelectric device, and apparatus including the piezoelectric device.

### Discussion of the Related Art

Piezoelectric materials are being widely used as materials of parts such as ultrasound vibrators, electromechanical transducers, and actuators used in the broad field such as ultrasound apparatuses, image apparatuses, sound apparatuses, communication apparatuses, and sensors.

## SUMMARY

The inventors have recognized the following issue when developing and applying piezoelectric material.

$Pb(Zr, Ti)O_3$ (hereinafter referred to as PZT)-based materials are mostly used as materials of piezoelectric parts because of a high piezoelectric characteristic thereof. However, lead (Pb) is a material having strong toxicity and causes severe environmental pollution in a sintering process due to strong volatility.

Therefore, because the PZT-based piezoelectric materials which are the most of piezoelectric materials cause a problem of environmental pollution, development of Pb-free piezoelectric materials and a high piezoelectric characteristic is needed.

Accordingly, the present disclosure is directed to providing a piezoelectric material composition, a method of manufacturing the same, a piezoelectric device, and an apparatus ora display apparatus including the piezoelectric device that substantially obviate one or more problems due to limitations and disadvantages of the related art.

An aspect of the present disclosure is directed to providing a piezoelectric material composition which does not include lead (Pb) and has a high piezoelectric characteristic.

Another aspect of the present disclosure is directed to providing a method of manufacturing a piezoelectric material composition, which may align grains by using a template so as to provide a piezoelectric material composition having a high piezoelectric characteristic, thereby enhancing a piezoelectric characteristic.

Another aspect of the present disclosure is directed to providing a piezoelectric device having a high piezoelectric characteristic and a display apparatus including the piezoelectric device.

Another aspect of the present disclosure is directed to providing a piezoelectric device including a composition of various combinations for developing a material where an R-O-T structure having a high R-O ratio is provided at a room temperature, and moreover, directed to a piezoelectric device capable of implementation of performance of a high-performance material through a process.

Accordingly, some embodiments of the present disclosure are to provide an apparatus that substantially obviates one or more of the problems due to limitations and disadvantages of the related art.

Additional features, advantages, and aspects of the present disclosure are set forth in the present disclosure and will also be apparent from the present disclosure, or may be learned by practice of the inventive concepts provided herein. Other features, advantages, and aspects of the present disclosure may be realized and attained by the descriptions provided in the present disclosure, or derivable therefrom, and the claims hereof as well as the appended drawings.

To achieve these and other advantages and aspects of the present disclosure, as embodied and broadly described herein, a piezoelectric material composition is represented by Formula 1: $0.96(Na_aK_{1-a})(Nb_b(T_{1-b}))O_3$-$(0.04-x)MZrO_3$-$x(Bi_cAg_{1-c})ZrO_3$ + d mol% $NaNbO_3$, where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

In another aspect of the present disclosure, the method of manufacturing a piezoelectric material composition may comprise mixing a matrix material with a seed material to prepare a slurry, molding the slurry to prepare a molding element, and sintering the molding element to prepare a sintered material. The matrix material and seed material are represented by Formula 1: $0.96(Na_aK_{1-a})(Nb_b(T_{1-b}))O_3$-$(0.04-x)MZrO_3$-$x(Bi_cAg_{1-c})ZrO_3$ + d mol% $NaNbO_3$, where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

In another aspect of the present disclosure, a piezoelectric device may comprises a piezoelectric material layer, the piezoelectric material layer may comprises: a plurality of grains, each of which including a piezoelectric material composition having a first material and a second material, wherein, the piezoelectric material composition is represented by Formula 1: $0.96(Na_aK_{1-a})(Nb_b(T_{1-b}))O_3$-$(0.04-x)MZrO_3$-$x(Bi_cAg_{1-c})ZrO_3$ + d mol% $NaNbO_3$, where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

In another aspect of the present disclosure, a piezoelectric device may comprise a piezoelectric device layer including a piezoelectric material composition comprising a first material and a second material surrounded by the first material, a first electrode portion disposed at a first surface of the piezoelectric device layer, and a second electrode portion disposed at a second surface of the piezoelectric device layer opposite to the first surface. The piezoelectric material composition is represented by Formula 1: $0.96(Na_aK_{1-a})(Nb_b(T_{1-b}))O_3-(0.04-x)MZrO_3-x(Bi_cAg_{1-c})ZrO_3 + d$ mol% $NaNbO_3$, where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

In another aspect of the present disclosure, a display apparatus may comprise a display panel to display a screen or a vibration member, a piezoelectric device layer disposed at a surface of the display panel or the vibration member and including a first material layer and a second material layer surrounded by the first material layer, a first electrode portion disposed at a first surface of the piezoelectric device layer, and a second electrode portion disposed at a second surface of the piezoelectric device layer opposite to the first surface of the piezoelectric device layer.

According to some embodiments of the present disclosure, because a piezoelectric material composition does not include lead (Pb) and has a high piezoelectric characteristic, a piezoelectric device and a display apparatus each including the piezoelectric material composition may be driven with a low driving voltage and may be enhanced in piezoelectric characteristic.

Moreover, according to some embodiments of the present disclosure, comparing with a method of manufacturing a single grain, a method of manufacturing a piezoelectric material composition may be considerably reduced in time and cost, thereby considerably enhancing productivity.

Other systems, methods, features and advantages will be, or will become, apparent to one with skill in the art upon examination of the following figures and detailed description. It is intended that all such additional systems, methods, features and advantages be included within this description, be within the scope of the present disclosure, and be protected by the following claims. Nothing in this section should be taken as a limitation on those claims. Further aspects and advantages are discussed below in conjunction with embodiments of the disclosure.

It is to be understood that both the foregoing description and the following description of the present disclosure are exemplary and explanatory, and are intended to provide further explanation of the disclosure as claimed.

## BRIEF DESCRIPTION OF THE DRAWINGS

The accompanying drawings, which are included to provide a further understanding of the disclosure, are incorporated in and constitute a part of this disclosure, illustrate embodiments of the disclosure, and together with the description serve to explain principles of the disclosure.

FIG. 1 is a flowchart illustrating a method of manufacturing a piezoelectric material composition according to an embodiment of the present disclosure.

FIG. 2 is a cross-sectional view illustrating a piezoelectric material composition according to an embodiment of the present disclosure.

FIG. 3 illustrates a crystal structure of a piezoelectric material composition according to an embodiment of the present disclosure.

FIGs. 4A, 4B, and 4C illustrate tetragonal (T), orthorhombic (O), and rhombohedral (R) crystallographic azimuths of a piezoelectric material composition according to an embodiment of the present disclosure.

FIG. 5 illustrates a phase transition temperature based on a temperature variation of a piezoelectric device according to an embodiment of the present disclosure.

FIGs. 6A and 6B illustrate piezoelectric performance based on a domain size according to an embodiment of the present disclosure.

FIG. 7 illustrates a density, a dielectric constant $\varepsilon^T_{33}/\varepsilon_0$, a loss factor $\tan\delta$, a piezoelectric charge constant $d_{33}$, and an electromechanical coupling factor $k_\rho$ (or a mechanical quality factor) based on a seed content mol% of $NaNbO_3$ of a piezoelectric material composition according to an embodiment of the present disclosure.

FIG. 8 illustrates a lotgering factor based on a seed content of a piezoelectric material composition according to an embodiment of the present disclosure.

FIG. 9 illustrates a phase transition temperature when a seed of 3 mol% is applied to a piezoelectric material composition according to an embodiment of the present disclosure.

FIG. 10 illustrates photographs (a), (b), (c), (d) and (e) of a microstructure based on a piezoelectric material composition according to an embodiment of the present disclosure.

FIG. 11 is a flowchart illustrating a method of manufacturing a matrix material of a piezoelectric material composition according to an embodiment of the present disclosure.

FIG. 12 shows XRD data of a matrix material according to an embodiment of the present disclosure.

FIGs. 13A to 13E show diffraction peaks of a matrix material according to an embodiment of the present disclosure.

FIG. 14 illustrates cross-sectional photographs (a), (b), (c), (d) and (e) of a matrix material according to an embodiment of the present disclosure.

FIG. 15A shows a variation of a dielectric constant value based on a temperature of a matrix material according to an embodiment of the present disclosure, and FIGs. 15B to 15F show variations of a dielectric constant and a loss factor based on an increase in a BAZ ((Bi, Ag) $ZrO_3$) content of the matrix material according to an embodiment of the present disclosure.

FIGs. 16A to 16E are temperature dielectric constant graphs based on different frequencies with respect to an increase in a BAZ content of the matrix material according to an embodiment of the present disclosure.

FIGs. 17A and 17B are transmission electron microphotographs of a matrix material according to an embodiment of the present disclosure.

FIG. 18 illustrates a relative density, a dielectric constant $\varepsilon^T_{33}/\varepsilon_0$, a piezoelectric charge constant $d_{33}$, and an electromechanical coupling factor $k_\rho$ of a matrix material according to an embodiment of the present disclosure.

FIG. 19A is a piezoelectric charge constant based on a poling temperature of a matrix material according to an embodiment of the present disclosure, FIG. 19B is a piezoelectric charge constant based on an electric field according to an embodiment of the present disclosure, and FIG. 19C is a piezoelectric charge constant based on an annealing temperature according to an embodiment of the present disclosure.

FIG. 20 is a flowchart illustrating a method of manufacturing a seed of a piezoelectric material composition according to an embodiment of the present disclosure.

FIG. 21 illustrates a grain variation occurring in a step of preparing a secondary seed according to an embodiment of the present disclosure.

FIG. 22 is a perspective view of a display apparatus according to an embodiment of the present disclosure.

FIG. 23 is a cross-sectional view taken along line I-I' of FIG. 22 according to an embodiment of the present disclosure.

FIG. 24 illustrates a piezoelectric device of FIG. 23 according to an embodiment of the present disclosure.

Throughout the drawings and the detailed description, unless otherwise described, the same drawing reference numerals should be understood to refer to the same elements, features, and structures. The relative sizes, lengths, and thicknesses of layers, regions and elements, and depiction thereof may be exaggerated for clarity, illustration, and convenience.

## DETAILED DESCRIPTION

Reference is now made in detail to embodiments of the present disclosure, examples of which may be illustrated in the accompanying drawings. In the following description, when a detailed description of well-known functions or configurations may unnecessarily obscure aspects of the present disclosure, the detailed description thereof may be omitted for brevity. The progression of processing steps and/or operations described is an example; however, the sequence of steps and/or operations is not limited to that set forth herein and may be changed, with the exception of steps and/or operations necessarily occurring in a particular order.

Unless stated otherwise, like reference numerals may refer to like elements throughout even when they are shown in different drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are provided so that this disclosure is thorough and complete and fully conveys the scope of the present disclosure to those skilled in the art. Furthermore, the present disclosure is only defined by claims and their equivalents.

The shapes, sizes, areas, ratios, angles, numbers, and the like disclosed in the drawings for describing embodiments of the present disclosure are merely examples, and thus, the present disclosure is not limited to the illustrated details.

When the term "comprise," "have," "include," "contain," "constitute," "make up of," "formed of," or the like is used, one or more other elements may be added unless a term such as "only" or the like is used. The terms used in the present disclosure are merely used in order to describe particular embodiments, and are not intended to limit the scope of the present disclosure. The terms used herein are merely used in order to describe example embodiments, and are not intended to limit the scope of the present disclosure. The terms of a singular form may include plural forms unless the context clearly indicates otherwise. The word "exemplary" is used to mean serving as an example or illustration. Embodiments are example embodiments. Aspects are example aspects. Any implementation described herein as an "example" is not necessarily to be construed as preferred or advantageous over other implementations.

In one or more aspects, an element, feature, or corresponding information (e.g., a level, range, dimension, size, or the like) is construed as including an error or tolerance range even where no explicit description of such an error or tolerance range is provided. An error or tolerance range may be caused by various factors (e.g., process factors, internal or external impact, noise, or the like). Further, the term "may" encompasses all the meanings of the term "can."

In describing a positional relationship, where the positional relationship between two parts is described, for example, using "on," "over," "under,""above," "below," "beneath," "near," "close to," or "adjacent to," "beside," "next to," or the like one or more other parts may be located between the two parts unless a more limiting term, such as "immediate(ly)," "direct(ly)," or "close(ly)," is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which one or more additional structures are disposed or interposed therebetween. Furthermore, the terms "front," "rear," "back," "left," "right," "top," "bottom," "downward," "upward," "upper," "lower," "up," "down," "column," "row," "vertical," "horizontal," and the like refer to an arbitrary frame of reference.

In describing a temporal relationship, when the temporal order is described as, for example, "after," "subsequent," "next," "before," "preceding," "prior to," or the like, a case that is not consecutive or not sequential may be included unless a more limiting term, such as "just," "immediate(ly)," or "direct(ly)," is used.

It is understood that, although the term "first," "second," etc. may be used herein to describe various elements, these elements should not be limited by these terms. These terms are only used to distinguish one element from another. For example, a first element could be a second element, and, similarly, a second element could be a first element, without departing from the scope of the present disclosure. Furthermore, the first element, the second element, and the like may be arbitrarily named according to the convenience of those skilled in the art without departing from the scope of the present disclosure. The terms "first," "second," and the like may be used to distinguish components from each other, but the functions or structures of the components are not limited by ordinal numbers or component names in front of the components.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element or layer is "connected," "coupled," or "adhered" to another element or layer, the element or layer can not only be directly connected, coupled, or adhered to another element or layer, but also be indirectly connected, coupled, or adhered to another element or layer with one or more intervening elements or layers disposed or interposed between the elements or layers, unless otherwise specified.

For the expression that an element or layer "contacts," "overlaps," or the like with another element or layer, the element or layer can not only directly contact, overlap, or the like with another element or layer, but also indirectly contact, overlap, or the like with another element or layer with one or more intervening elements or layers disposed or interposed between the elements or layers, unless otherwise specified.

The term "at least one" should be understood as including any and all combinations of one or more of the associated listed items. For example, the meaning of "at least one of a first item, a second item, and a third item" denotes the combination of items proposed from two or more of the first item, the second item, and the third item as well as only one of the first item, the second item, or the third item.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C. Furthermore, an expression "element A/element B" may be understood as element A and/or element B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two.

In one or more aspects, the phrases "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

Features of various embodiments of the present disclosure may be partially or wholly coupled to or combined with each other, and may be variously interoperated, linked or driven together. The embodiments of the present disclosure may be carried out independently from each other, or may be carried out together in a codependent or related relationship. In one or more aspects, the components of each apparatus according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

Hereinafter, embodiments of the present disclosure will be described in detail with reference to the accompanying drawings.

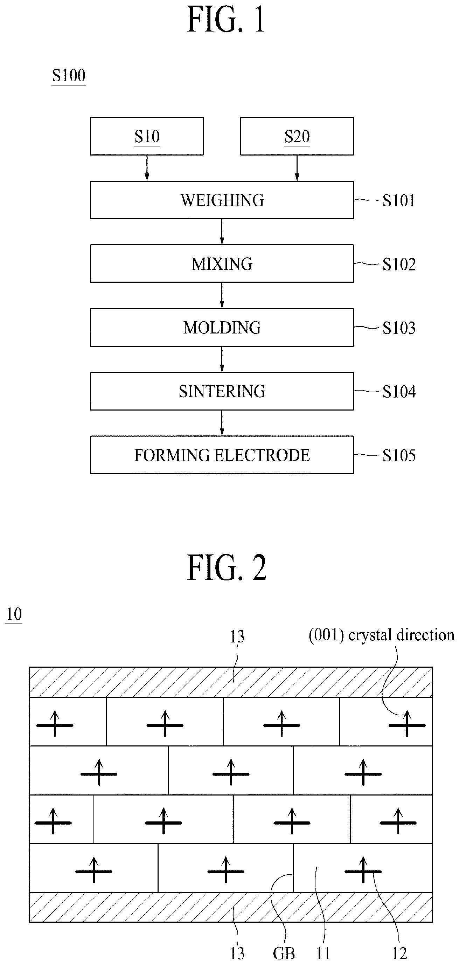

FIG. 1 is a flowchart illustrating a method of manufacturing a piezoelectric material composition according to an embodiment of the present disclosure.

Referring to FIG. 1, a method of manufacturing a piezoelectric material composition according to an embodiment of the present disclosure may include step S101 of weighing a matrix material of a piezoelectric material composition, step S102 of mixing the weighed matrix materials, step S103 of molding the matrix material, step S104 of sintering a molded piezoelectric material composition, and step S105 of forming an electrode on the sintered piezoelectric material composition. A condition based on the method of manufacturing the piezoelectric material composition may include, for example, a temperature, viscosity, and a time, but embodiments of the present disclosure are not limited thereto.

First, step S101 of weighing the matrix material of the piezoelectric material composition may be a step of weighing each of materials respectively prepared to satisfy a mole ratio of the following Formula 1 by using a method S10 of preparing a matrix material and a method S20 of preparing a seed material. Step S101 of weighing the matrix material may be dispensable or performed separately from the manufacturing method. For example, a method of manufacturing a piezoelectric material composition according to an embodiment of the present disclosure may start with mixing a matrix material pre-prepared in the mole ratio by another entity.

The piezoelectric material composition may be prepared to satisfy the following 1 Formula 1.

$$\text{Formula 1} \qquad 0.96(Na_aK_{1-a})(Nb_b(T_{1-b}))O_3\text{-}(0.04\text{-}x)MZrO_3\text{-}x(Bi_cAg_{1-c})ZrO_3 + d \text{ mol\% } NaNbO_3$$

Here, T may be Sb or Ta, M may be Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

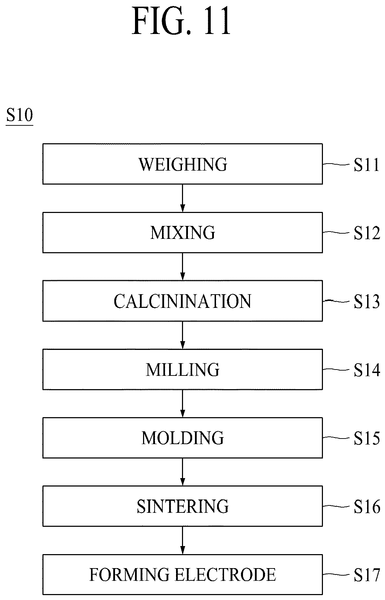

For example, the matrix material may be a component except $NaNbO_3$ which is a seed, in the Formula 1, and may be prepared by the method S10 of preparing the matrix material which will be described with reference to FIG. 11, but embodiments of the present disclosure are not limited thereto.

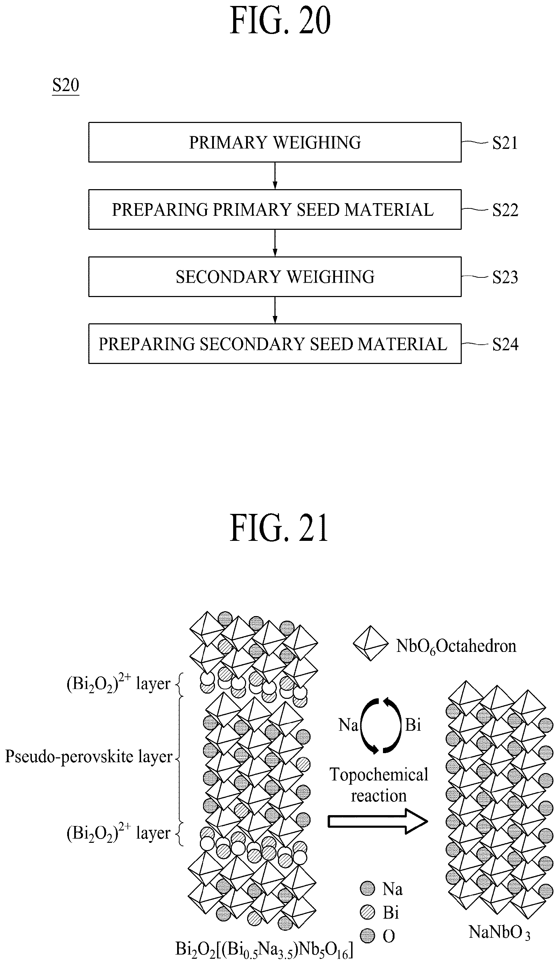

The seed material may have $NaNbO_3$ having an average particle size of 10 $\mu$m or more, and an aspect ratio of the seed material may be within a range of 5 to 20, or a range of 10 to 15 and may be prepared by the method S20 of preparing the seed material which will be described with reference to FIG. 20.

The amount if the seed material added to the piezoelectric material composition of formula 1 may be 1 mol% to 5 mol%, and for example, may be 3 mol%, but embodiments of the present disclosure are not limited thereto.

Subsequently, step S102 of mixing the weighed matrix materials may be a step of mixing the seed material and the weighed matrix material which are weighed in a previous step.

A step of generating a synthesized matrix material may include a step of preparing a slurry composed of the matrix material and a step of mixing the seed material with the slurry including the matrix material.

For example, the step of preparing the slurry including the matrix material may add an appropriate amount of dispersant and solvent to the matrix material having a composition of Formula 1. For example, the solvent may include one or more of ethanol, methanol, isopropanol, methyl ethyl ketone (MEK), toluene, and distilled water, but embodiments of the present disclosure are not limited thereto. By adding an appropriate amount of dispersant and solvent to the matrix material, a slurry where the matrix material is well dispersed in the solvent may be prepared. According to some embodiments of the present disclosure, the dispersant may be used for decreasing the viscosity of the slurry including the matrix material.

Moreover, ball milling may be performed by further adding an appropriate amount of binder and plasticizer to a previously prepared matrix material slurry. The binder may provide the stiffness, flexibility, ductility, durability, durableness, and smoothness of a green tape. The binder may include at least one of polyvinyl butyral (PVB) resin, polyvinyl alcohol (PVA), and polyethylene glycol (PEG), but embodiments of the present disclosure are not limited thereto and a binder known to those skilled in the field of piezoelectric material composition may be used. The plasticizer may be added for providing the elasticity and plastic characteristic of the green tape. The plasticizer may include at least one of phthalate-based plasticizer, adipate-based plasticizer, phosphate-based plasticizer, poly ether-based plasticizer, and polyester-based plasticizer, and a plasticizer material known to those skilled in the field of piezoelectric material composition may be used.

The step of mixing the seed material with the matrix material may be a step of mixing the seed material with the slurry including the matrix material which is prepared in a previous step and may be performed through a milling process, and moreover, may be performed at a low speed (for example, 40 rpm) in a no-ball state for a time which is relatively shorter than another mixing step, but embodiments of the present disclosure are not limited thereto.

Moreover, the method may further include an aging step and a degassing step of removing an air bubble and a gas after the seed material is added to and mixed with the slurry including the matrix material.

The degassing step may be a step of adjusting the slurry to have appropriate viscosity for a molding (or press molding) process in a below-describe step of molding (or press molding) a piezoelectric material. For example, the degassing step may be adjusted to have a viscosity of 1,700 cPs (centipoise) to 2,400 cPs by using a vacuum stirrer at a room temperature, or 1,900 cPs (centipoise) to 2,200 cPs, or be adjusted to 2000 cPs (centipoise), but embodiments of the present disclosure are not limited thereto.

The aging step may be a step of adjusting a temperature to a room temperature again because the slurry is cooled when a solvent is volatilized in the degassing step. For example, in the aging step, stirring may be performed for a short time at a low speed of about 40 rpm by using the stirrer, but embodiments of the present disclosure are not limited thereto.

Subsequently, step S103 of molding (or press molding) the piezoelectric material may be a step of manufacturing a molded element having a certain volume and shape by using the slurry where the seed material and the matrix material prepared in step S102 are mixed.

For example, the step of molding (or press molding) the piezoelectric material may include a step of performing tape casting, a step of primarily molding (or press molding) the tape-casted piezoelectric material, and a step of secondarily molding (or press molding) the primarily molded piezoelectric material, but embodiments of the present disclosure are not limited thereto.

The tape casting step may be a step of tape-casting, by using a tape casting device, the slurry where the seed material and the matrix material prepared in the step are mixed, and in a case where the slurry is tape-casted to have a viscosity of 1,700 cPs to 2,400 cPs, the slurry may be casted to have a thickness of about 30 $\mu$m.

The step of primarily molding (or press molding) the tape-casted piezoelectric material may be performed through warm isostatic press (WIP), the step of secondarily molding (or press molding) the tape-casted piezoelectric material may be performed through cold isostatic press (CIP), and these processes may be used for increasing a density of a sintered material in a sintering step described below. Also, in the piezoelectric material composition according to some embodiments of the present disclosure, the WIP may be performed when a molded element (or a molded material) is prepared based on lamination and stack such as tape casting.

Moreover, step S103 of molding (or press molding) the piezoelectric material may further include a degreasing step after the primary molding (or press molding) step, and the degreasing step may be a step of removing a solvent or an organic material. The degreasing step may perform furnace cooling up to a room temperature after being maintained for about 40 hours within a temperature range of 300 °C to 600 °C in a furnace.

Subsequently, step S104 of sintering a molded element (or a molded material) will be described.

The sintering step may perform furnace cooling after being performed in one temperature period. For example, a sintering temperature may be 1,090 °C, and a maintenance time may be 3 hours, but embodiments of the present disclosure are not limited thereto. For example, a sintering temperature may be 1,000 °C to 1,150 °C, and a maintenance time may be 1 hour to 10 hours, but embodiments of the present disclosure are not limited thereto.

Subsequently, step S105 of forming an electrode in a sintered element (or a sintered material) may be performed.

An electrode may be formed in a first surface of a sintered material of a piezoelectric material prepared in the step and a second surface opposite to the first surface. For example, the electrode may be formed by coating metal, such as silver (Ag), but embodiments of the present disclosure are not limited thereto and a general electrode known to those skilled in the art may be used without being limited.

FIG. 2 is a cross-sectional view illustrating a piezoelectric material according to an embodiment of the present disclosure;

Referring to FIG. 2, a piezoelectric material 10 according to some embodiments of the present disclosure may include a plurality of grains (or crystal grains) including a first material 11 and a second material 12. The grains including the first material 11 and the second material 12 may be divided by a grain boundary (GB).

The second material 12 may be formed in the first material 11. In the first material 11, a grain boundary may be grown based on a crystal direction of the second material 12, and thus, a plurality of first materials 11 may have the same or substantially the same crystal direction, and for example, the first material 11 may have a (001) crystal direction, but embodiments of the present disclosure are not limited thereto. Accordingly, the first material 11 may be disposed to surround the second material 12.

The second material 12 may be disposed at a center portion of the first material 11. Here, the center portion may not be a numerically and accurately half in the first material 11 having a certain volume but may be a certain region including a center of the first material 11, and moreover, may be within a range of the present disclosure even when the second material 12 is disposed at a position outside the center of the first material 11. For example, in a growth of a crystal direction, the second material 12 may be disposed in the first material 11 and may be disposed close to or adjacent to a grain boundary GB which is a boundary between the plurality of first materials 11, but embodiments of the present disclosure are not limited thereto.

Moreover, the piezoelectric material 10 may further include an electrode portion 13 which is formed on each of a first surface and a second surface opposite to the first surface of a sintered material including the first material 11 and the second material 12, and having a certain thickness. The piezoelectric material 10 may function as a piezoelectric device in a case where the electrode portion 13 is further included therein.

The first material 11 may include a matrix material. The first material 11 may be prepared by the method S10 of preparing a matrix material described below.

The second material 12 may be a seed material. The second material 12 may be prepared by the method S20 of preparing a seed material described below.

The second material 12 may act as a template so that the first material 11 grows in a crystal direction of the second material 12 in the sintering step S104 of the method S100 of manufacturing the piezoelectric material composition according to some embodiments of the present disclosure. For example, the first material 11 may be sintered based on the crystal direction of the second material 12 and may be grown so that a crystal direction is aligned in the same direction, but embodiments of the present disclosure are not limited thereto.

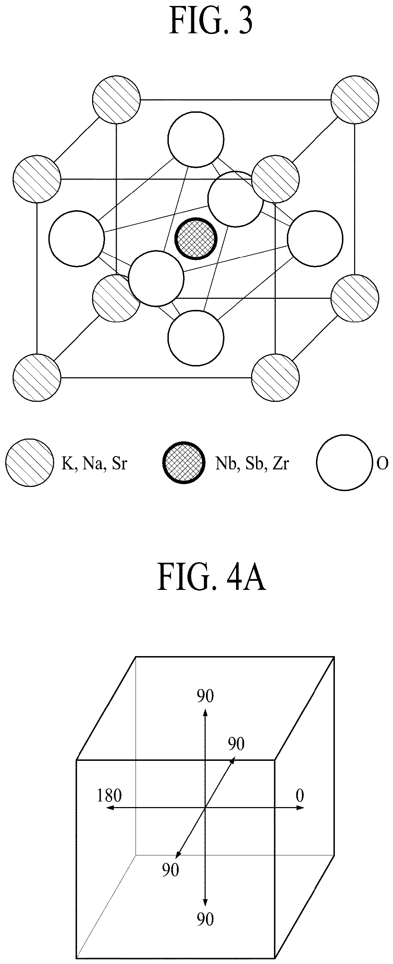

FIG. 3 illustrates a crystal structure of a piezoelectric material according to an embodiment of the present disclosure.

Referring to FIG. 3, a piezoelectric material based on a composition of Formula 1 according to some embodiments of the present disclosure may have a structure of $ABX_3$. Here, A may be a first positive ion, B may be a second positive ion, and X may be a negative ion which is bonded thereto. The first positive ion may be potassium ion ($K^+$), sodium ion ($Na^+$), strontium ion ($Sr^{+2}$), bismuth ion ($Bi^{+3}$), or silver ion ($Ag^+$), the second positive ion may be niobium ion ($Nb^{+5}$), antimony ion ($Sb^{+3}$), or zirconium ion ($Zr^{+4}$), and the negative ion may be oxygen (O). The first positive ion and the negative ion may configure a cube-octahedral structure of $AX_{12}$, and the second positive ion and the negative ion may be $BX_6$ and may have a structure bonded in an octahedral structure.

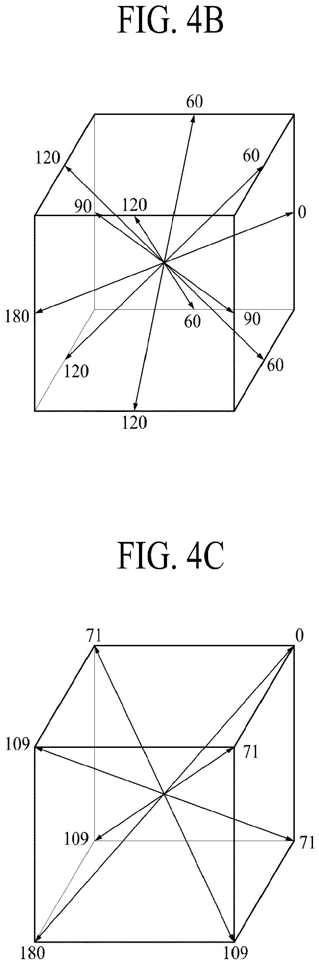

FIGs. 4A, 4B, and 4C illustrate orthorhombic (O), tetragonal (T), and rhombohedral (R) crystallographic azimuths of a piezoelectric material composition according to an embodiment of the present disclosure, respectively.

Referring to FIGs. 4A to 4C, the piezoelectric performance of a piezoelectric ceramic according to some embodiments of the present disclosure may increase as the number of crystallographic orientations of self-polarization increases. An orthorhombic structure may have six crystallographic orientations, a tetragonal structure may have twelve crystallographic orientations, and a rhombohedral structure may have eight crystallographic orientations. Composition optimization where a tetragonal (T), orthorhombic (O), and rhombohedral (R) (hereinafter R-O-T) crystal structure is provided together may be needed for increasing piezoelectric performance.

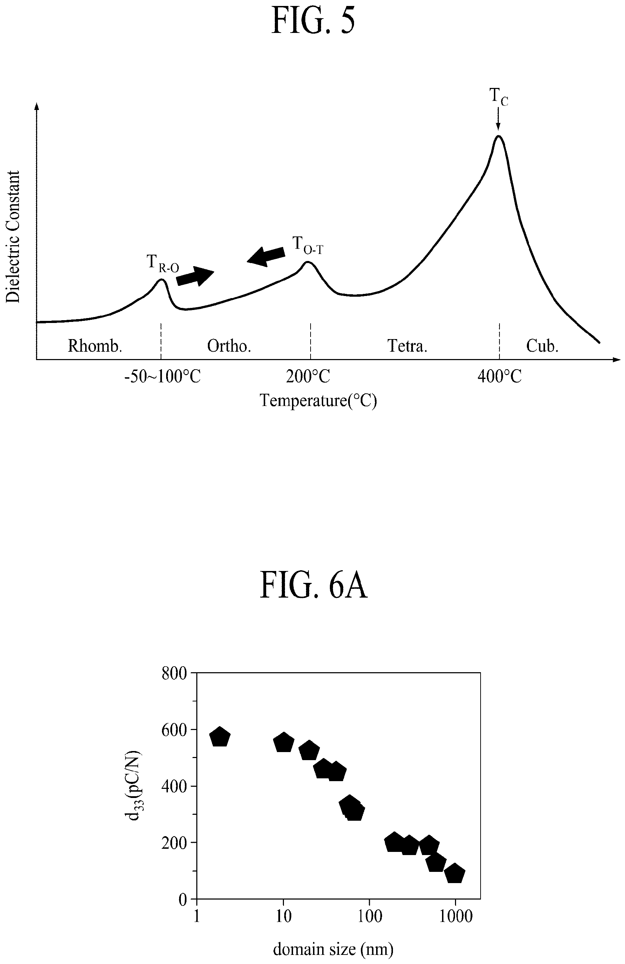

FIG. 5 illustrates a phase transition temperature based on a temperature variation of a piezoelectric device. For example, FIG. 5 illustrates a phase transition temperature based on a temperature variation of a pure $(Na_{0.5}K_{0.5})NbO_3$ piezoelectric device.

Referring to FIG. 5, it may be seen that there is $T_{R-O}$ at temperature of about to -50 °C to about -100 °C and there is $T_{O-T}$ at about 200 °C. By adding Bi, Ag, Sr, Sb, and Zr to pure $(Na_{0.5}K_{0.5})NbO_3$, a material where the R-O-T structure coexist may be produced at a room temperature.

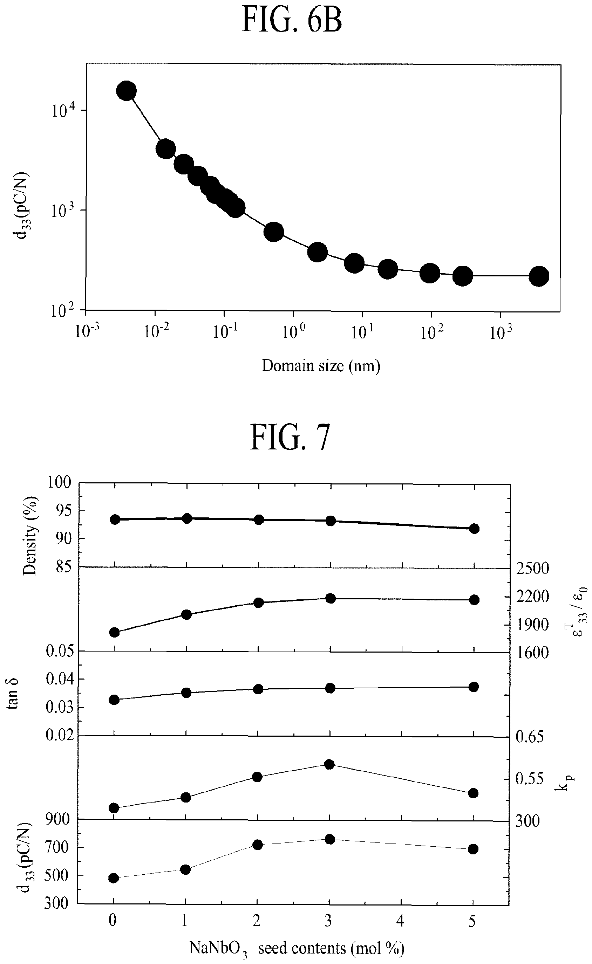

FIGs. 6A and 6B illustrate piezoelectric performance based on a domain size.

Referring to FIGs. 6A and 6B, it may be seen that a piezoelectric charge constant $d_{33}$ value increases progressively as a domain size is reduced, and thus, domain boundary energy is progressively reduced as the domain size decreases, and domain rotation is easily performed, thereby contributing to enhance a piezoelectric characteristic.

FIG. 7 illustrates a density, a dielectric constant $\varepsilon^T_{33}/\varepsilon_0$, a loss factor $\tan\delta$, a piezoelectric charge constant $d_{33}$, an electromechanical coupling factor $k_\rho$, and a mechanical quality factor based on a seed content mol% of $NaNbO_3$ of a piezoelectric material composition according to an embodiment of the present disclosure. A piezoelectric material composition of FIG. 7 has been prepared as a $(Na,K,Sr,Bi,Ag)(Nb,Sb,Zr)O_3$ composition and a seed of $NaNbO_3$ has been added.

Referring to FIG. 7, it may be seen that a seed content (mol%) of $NaNbO_3$ has a density of more than 93% within a range of 0 mol% to 3 mol%. For example, a seed content (mol%) of $NaNbO_3$ has a density of 90.1% when a seed content (mol%) of $NaNbO_3$ is 5 mol% , but embodiments of the present disclosure are not limited thereto.

It may be seen that a dielectric constant $\varepsilon^T_{33}/\varepsilon_0$ represents that a value where a seed content (mol%) of $NaNbO_3$ within a range of 2 mol% to 5 mol% is more than 2,000. For example, when a $NaNbO_3$ seed is not added, a dielectric constant value is about 1,800, and when the $NaNbO_3$ seed is added by 1 mol%, a dielectric constant value is about 1,990, but embodiments of the present disclosure are not limited thereto.

It may be seen that a loss factor $\tan\delta$ represents a value of about 0.033 when a seed content (mol%) of $NaNbO_3$ is 0 mol%, and represents a value of more than 0.035 within a range where a seed content (mol%) of $NaNbO_3$ is 1 mol% to 5 mol%.

A piezoelectric charge constant $d_{33}$ represents a value of about 478 pC/N when a seed content (mol%) of $NaNbO_3$ is 0 mol%, represents a value of about 538 pC/N when a seed content (mol%) of $NaNbO_3$ is 1 mol%, and represents a value of 689 pC/N or more within a range of 2 mol% to 5 mol%. For example, the piezoelectric charge

constant $d_{33}$ represents a value of 760 pC/N when a seed content (mol%) of $NaNbO_3$ is 3 mol%, but embodiments of the present disclosure are not limited thereto.

It may be seen that an electromechanical coupling factor $k_\rho$ represents a value of about 0.476 when a seed content (mol%) of $NaNbO_3$ is 0, and represents a value of more than 0.5 within a range where a seed content (mol%) of $NaNbO_3$ is 1 mol% to 5 mol%, and for example, represents a value of 0.58 when a seed content (mol%) of $NaNbO_3$ is 3 mol%, but embodiments of the present disclosure are not limited thereto.

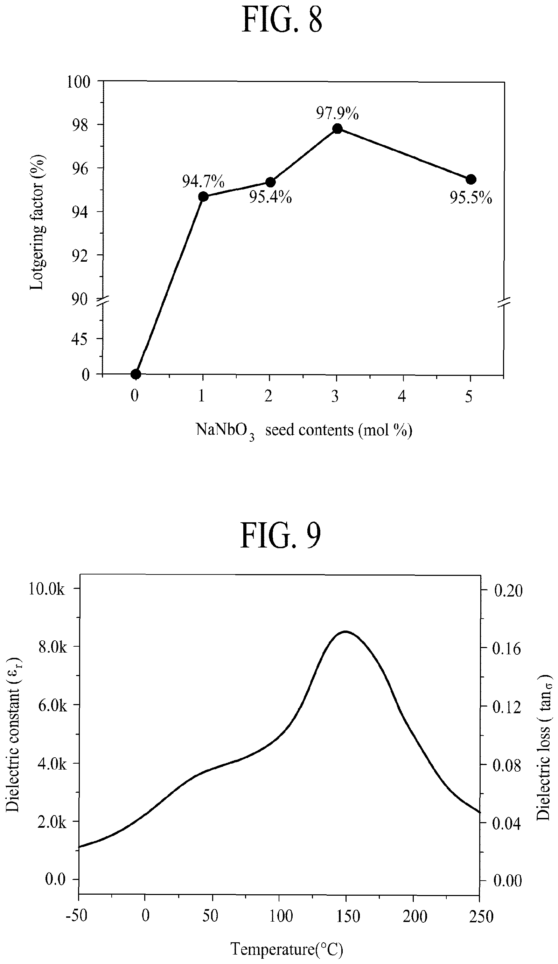

FIG. 8 illustrates a lotgering factor based on a seed content of a piezoelectric material composition. In FIG. 8, a composition of a piezoelectric material composition used in measurement has used $(Na,K,Sr,Bi,Ag)(Nb,Sb,Zr)O_3$.

Here, a lotgering factor $L_f(\%)$ may be expressed as the following Equation 1.

$$[\text{Equation 1}]$$
$$L_f(\%) = \frac{p - p_0}{1 - p_0}$$

Here p may denote the degree of orientation calculated by Equation 2, and po may be a fraction of $I_{001}$ in a piezoelectric material composition having the same or substantially the same composition which is aligned at random. The degree of orientation p may be calculated as the following Equation 2.

$$[\text{Equation 2}]$$
$$p = \frac{\Sigma I_{00\ell}}{\Sigma I_{00\ell} + \Sigma I_{non-00\ell}}$$

In Equation 2, $I_{(001)}$ may denote a diffraction peak such as (001) and (002) expressed as (001), and $I_{non-(001)}$ may denote a diffraction peak such as (110), (111), (210), and (211), which are not expressed as (001).

Referring to FIG. 8, it may be seen that orientation is not performed when a seed is not added to a piezoelectric material composition, and a seed content (mol%) of $NaNbO_3$ is 0 mol%, it may be seen that lotgering factor of 94.7% or more is shown within a range where a seed content (mol%) of $NaNbO_3$ is in the range of 1 mol% to 5 mol%, and it may be seen that the degree of crystal direction is highest when a seed content (mol%) of $NaNbO_3$ is 3 mol%.

Referring to FIGs. 7 and 8, it may be seen that a density, a dielectric constant, a loss factor, a piezoelectric charge constant, an electromechanical coupling factor, and a mechanical quality factor improve within a range where a seed content (mol%) of $NaNbO_3$ is 1 mol% to 5 mol%, and the degree of crystal orientation increases.

FIG. 9 illustrates a phase transition temperature when a seed of 3 mol% is applied to a piezoelectric material composition. In FIG. 9, a composition of a piezoelectric material composition used in measurement includes a piezoelectric material composition having the following formula: $0.96(Na_{0.5}K_{0.5})(Nb_{0.93}Sb_{0.07})O_3$-$0.02(SrZr)O_3$-$0.02(Bi_{0.5}Ag_{0.5})ZrO_3$.

Referring to FIG. 9, it may be seen that a phase transition region of an orthorhombic-tetragonal is provided at about 41 °C, and a phase transition of a tetragonal-cubic is performed at about 151 °C.

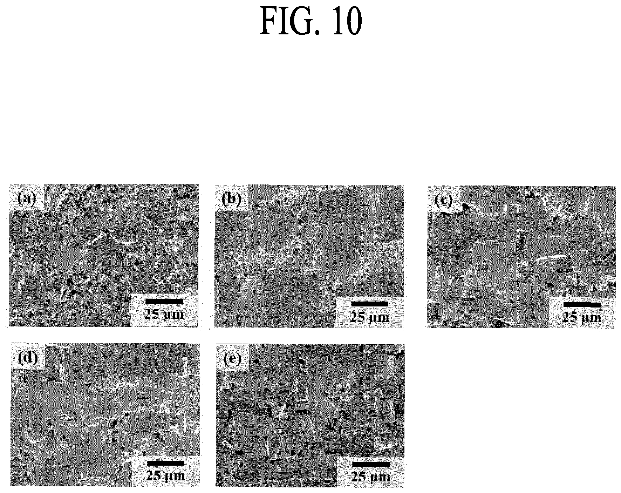

FIG. 10 illustrates photographs (a), (b), (c), (d) and (e) of a microstructure based on a piezoelectric material composition according to an embodiment of the present disclosure. In FIG. 10, a composition of a piezoelectric material composition used in measurement includes a piezoelectric material composition having the following formula: $0.96(Na_{0.5}K_{0.5})(Nb_{0.93}Sb_{0.07})O_3$-$0.02(SrZr)O_3$-$0.02(Bi_{0.5}Ag_{0.5})ZrO_3$ and has been photographed through measurement performed in a vertical direction with respect to a casted direction.

In photograph (a) of FIG. 10, it may be seen that a seed of $NaNbO_3$ is not used, and most of grains (or crystal grains) are provided to have a size of 20 $\mu$m or less.

In photographs (b), (c), (d), and (e) of FIG. 10, it may be seen that a seed of $NaNbO_3$ is 1 mol%, 2 mol%, 3 mol%, and 5 mol% in order, and most of grains (or crystal grains) are provided to have a size of 25 $\mu$m or more.

FIG. 11 is a flowchart illustrating a method of manufacturing a matrix material of a piezoelectric material composition according to an embodiment of the present disclosure.

Referring to FIG. 11, a method of manufacturing a matrix material of a piezoelectric material composition according to some embodiments of the present disclosure may include step S11 of weighing raw materials having Formula 2, step S12 of mixing the raw materials, a calcination step S13 of synthesizing the mixed raw materials, step S14 of milling a synthesized matrix material, step S15 of molding (or press molding) the milled matrix material, step S16 of sintering a matrix molding material, and step S17 of forming an electrode in a matrix sintered material. Step S11 of weighing the raw material may be dispensable or performed separately from the manufacturing method. For example, a method of manufacturing a matrix material according to some embodiments of the present disclosure may start with mixing a raw material pre-prepared having Formula 2 by another entity. A condition based on the method of manufacturing the piezoelectric material composition may include, for example, a temperature, pressure, and a time, but embodiments of the present disclosure are not limited thereto.

First, in the method of manufacturing a matrix material of a piezoelectric material composition according to some embodiments of the present disclosure, step S11 of weighing the raw material may be a step of weighing a matrix material based on a mole ratio to add an appropriate amount of solvent.

The matrix material may satisfy the following Formula 2.

$$\text{Formula 2} \qquad 0.96(Na_aK_{1-a})(Nb_b(T_{1-b}))O_3 - (0.04-x)MZrO_3 - x(Bi_cAg_{1-c})ZrO_3$$

Here, T may be Sb or Ta, M may be Sr, Ba or Ca, a may be $0.4 \leq a \leq 0.6$, b may be $0.90 \leq b \leq 0.98$, c may be $0.4 \leq c \leq 0.6$, and x may be $0 \leq x \leq 0.04$.

The matrix material satisfying Formula 2 may be $(Na,K,Sr,Bi,Ag)(Nb,Sb,Zr)O_3$, and iron oxide $(Fe_2O_3)$ of 0.5 mol% may be added for increasing sinterability.

The matrix material satisfying Formula 2 in a step of weighing may be weighed based on a mole ratio of a composition for synthesizing sodium carbonate $(Na_2CO_3)$, potassium carbonate $(K_2CO_3)$, niobium oxide $(Nb_2O_5)$, antimony oxide $(Sb_2O_3)$, strontium carbonate $(SrCO_3)$, zirconium oxide $(ZrO_2)$, calcium carbonate $(CaCO_3)$, bismuth oxide $(Bi_2O_3)$, silver oxide $(Ag_2O)$, and iron oxide $(Fe_2O_3)$ and may be put into a nylon jar, and then, an appropriate amount of solvent (for example, ethanol) may be added thereto, but embodiments of the present disclosure are not limited thereto.

Subsequently, the step of mixing the raw materials may be a step of mixing and milling the weighed raw material and ethanol for 24 hours by using a ball milling process. Also, the mixing step may further include a drying step of separating a powder mixed with the solvent after the mixing step. Here, the drying step may put the mixed raw materials into a dish and may sufficiently dry the mixed raw material at a temperature of about 100 °C.

Moreover, according to some embodiments of the present disclosure, step S12 of mixing the raw materials may further include the calcination step S13 of phase-synthesizing primarily mixed raw materials.

The calcination step S13 may be a step of finely grinding a dried compound with a mortar after mixing is completed, putting the grinded compound into an alumina crucible, increasing a temperature of the grinded compound in an electric furnace at a temperature increasing speed of 5 °C/min, calcining the compound for 6 hours at 850 °C, and naturally cooling the calcined compound at a room temperature. For example, a calcining temperature may be 800 °C to 900 °C, and a maintenance time may be 1 hour to 10 hours, but embodiments of the present disclosure are not limited thereto.

Subsequently, step S14 of grinding the phase-synthesized matrix material may be a step of putting a solvent (ethanol) into phase-synthesized matrix material and grinding the solvent-containing matrix material for 24 hours by using a ball milling process to decrease a size of a particle.

Moreover, the grinding step may further include a drying step of separating a powder mixed with a solvent after the grinding step. Here, the drying step may put the grinded matrix material into a dish and may sufficiently dry the grinded raw material at a temperature of 100 °C, and for example, drying may be performed for 3 hours, but embodiments of the present disclosure are not limited thereto.

Moreover, according to some embodiments of the present disclosure, step S14 of grinding the phase-synthesized matrix material may further include a step of sieving materials.

The sieving step may be a step of filtering out powder dried powders finely grinded by the mortar by using a 40-mesh sieve to produce powders including particles having a certain size or less. A powder passing through the 40-mesh sieve may have a size of 400 $\mu$m or less.

Subsequently, step S15 of molding (or a press molding) the milled matrix material may be a step of press molding the sieved powder.

For example, the step of molding (or press molding) the secondarily mixed material may be a step of putting the secondarily mixed material into a mold having a circular shape and press molding the secondarily mixed material, and pressure for press molding may be 100 kg/f (force). However, embodiments of the present disclosure are not limited thereto.

Subsequently, step S16 of sintering the matrix pressing element may be a step of sintering the matrix molded material at a predetermined sintering temperature.

For example, the sintering temperature may be performed within a range of 1,070 °C to 1,110 °C, and a sintering time may be maintained for 3 hours to 6 hours, but embodiments of the present disclosure are not limited thereto.

Subsequently, the step S17 of forming the electrode in the sinter may be a step of coating the electrode on one surface (or a first surface) of the matrix sintered material and the other surface (or a second surface) o thereof opposite to the one surface.

For example, the electrode coated on the sintered material may be metal, such as a silver (Ag) electrode, embodiments of the present disclosure are not limited thereto.

Moreover, step S17 may further include a step of poling a sintered material having an electrode after the electrode is coated (or formed), and the poling step may apply an electric field of 4 kV/mm in silicone oil at a temperature of 0 °C to 40 °C for about 30 minutes to align poling.

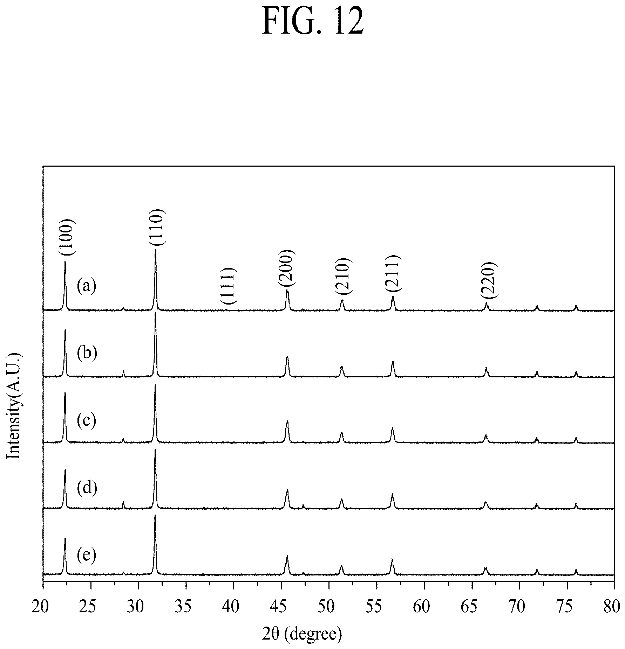

FIG. 12 shows X-ray diffraction pattern (XRD) data of a matrix material according to an embodiment of the present disclosure.

In FIG. 12, the X axis represents a $2\theta$ value of X-ray diffraction, and the ordinate axis represents relative intensity.

In FIG. 12, a composition of a matrix material having the following formula: $0.96(Na_{0.5}K_{0.5})(Nb_{0.93}Sb_{0.07})O_3$-$(0.04\text{-}x)CaZrO_3$-$x(Bi_{0.5}Ag_{0.5})ZrO_3$ was prepared through sintering performed for 3 hours at 1,090 °C. Also, a measurement of the X-ray diffraction pattern (XRD) was performed under a condition where (a) is set to x=0, (b) is set to x=0.01, (c) is set to x=0.02, (d) is set to x=0.03, and (e) is set to x=0.04.

Referring to FIG. 12, it may be seen that a uniform perovskite structure without secondary phase is provided over a total composition as the amount of addition of BAZ ($(Bi, Ag)ZrO_3$) increases.

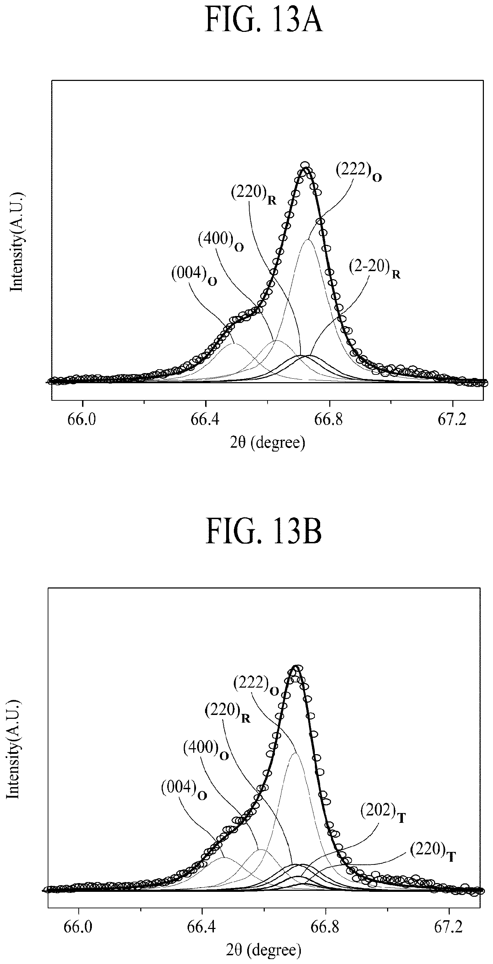

FIGs. 13A to 13E show diffraction peaks of a matrix material according to an embodiment of the present disclosure. The diffraction peak is a diffraction peak obtained by measuring 66.5° of a matrix material at a low speed of 0.3 °/min. FIGs. 13A to 13E show a small angle X-ray result, and the small angle X-ray is used for analyzing a $2\theta$ value within a range of 1 °C to 1.5 °C and analyzing a nano structure. In the present disclosure, the small angle X-ray has been used for observing phase coexistence and a phase transition within a corresponding range of $2\theta$.

In FIGs. 13A to 13E, the X axis represents a $2\theta$ value of X-ray diffraction, and the ordinate axis represents relative intensity.

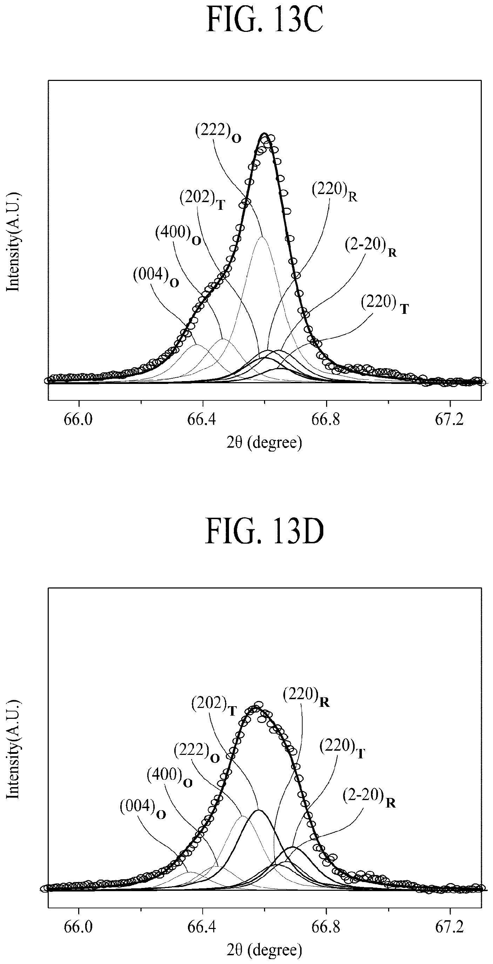

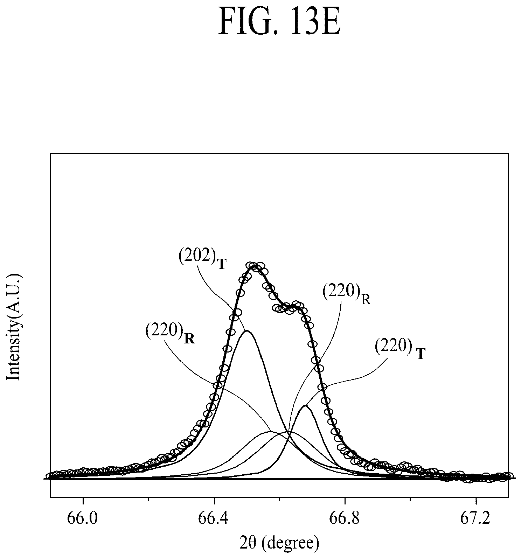

In FIGs. 13A to 13E, a composition of a matrix material having the following formula: $0.96(Na_{0.5}K_{0.5})(Nb_{0.93}Sb_{0.07})O_3$-$(0.04\text{-}x)CaZrO_3$-$x(Bi_{0.5}Ag_{0.5})ZrO_3$ was prepared through sintering performed for 3 hours at 1,090 °C. Also, a measurement of the diffraction peaks was performed under a condition where x=0 in FIG. 13A, x=0.01 in FIG. 13B, x=0.02 in FIG. 13C, x=0.03 in FIG. 13D, and x=0.04 in FIG. 13E.

Referring to FIG. 13A, when BAZ is not added, it may be seen that a rhombohedral (R) phase and an orthorhombic (O) phase coexist. Referring to FIGs. 13B to 13E, it may be seen that a tetragonal (T) phase increases progressively as the amount of addition of BAZ increases. Also, referring to FIG. 13E, when BAZ is added by x=0.04, it may be seen that a structure is provided where the orthorhombic (O) phase is removed and rhombohedral (R)-tetragonal (T) phases coexist.

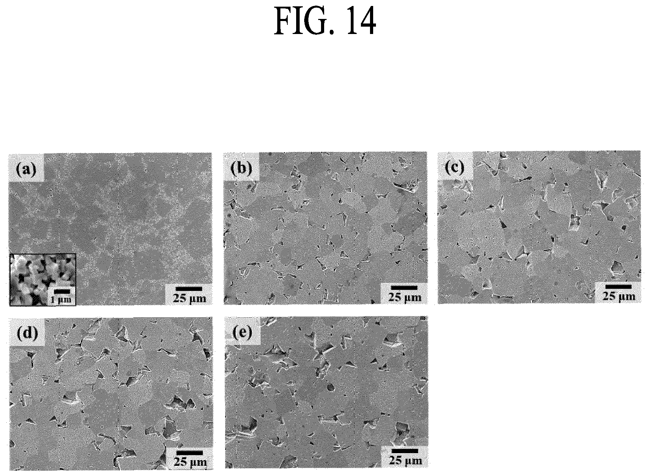

FIG. 14 illustrates cross-sectional photographs (a), (b), (c), (d) and (e) of a matrix material according to an embodiment of the present disclosure.

In FIG. 14, a matrix material including a composition having the following formula: $0.96(Na_{0.5}K_{0.5})(Nb_{0.93}Sb_{0.07})O_3$-$(0.04\text{-}x)CaZrO_3$-$x(Bi_{0.5}Ag_{0.5})ZrO_3$ was prepared, and $Fe_2O_3$ of 0.5 mol% was added for sinterability.

Photograph (a) of FIG. 14 shows a result obtained by polishing and photographing a break surface of a sample prepared under a condition where a is set to x=0, b is set to x=0.01, c is set to x=0.02, d is set to x=0.03, and e is set to x=0.04.

Referring to photograph (a) of FIG. 14, it may be seen that two kinds of grains including a large grain of 23 $\mu$m and a small grain of 0.5 $\mu$m are provided. Referring to photographs (b), (c), (d) and (e) of FIG. 14, it is shown that only grain having a large size is provided as a content of BAZ increases. This denotes that BAZ affect growth of a grain. Also, it may be seen that a piezoelectric characteristic increases as a size of a grain increases, based on a characteristic where a piezoelectric characteristic increases as a size of a grain increases.

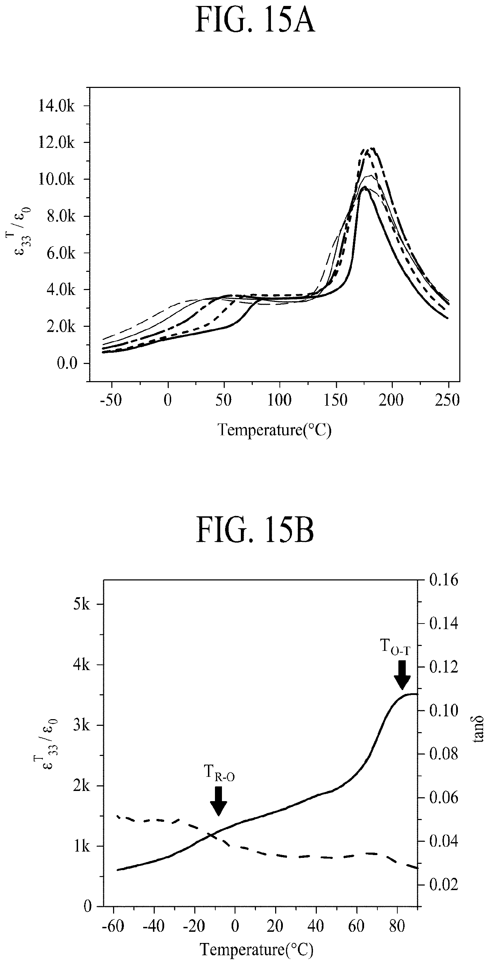

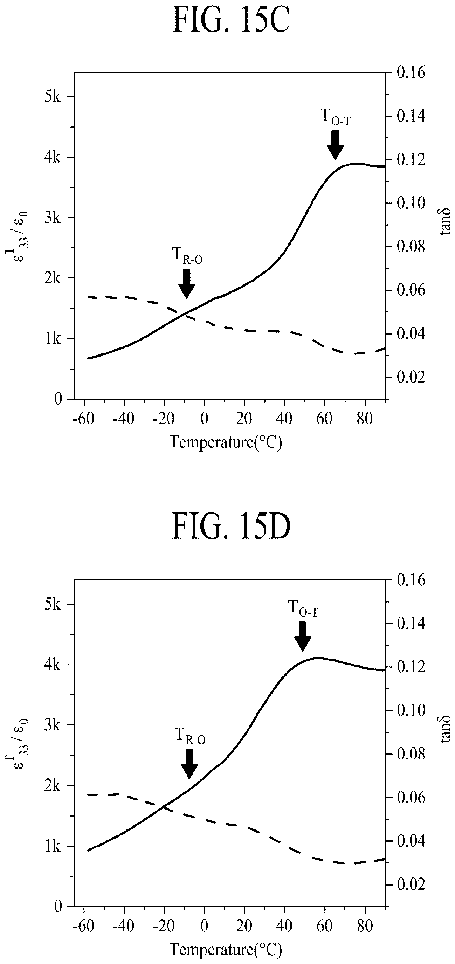

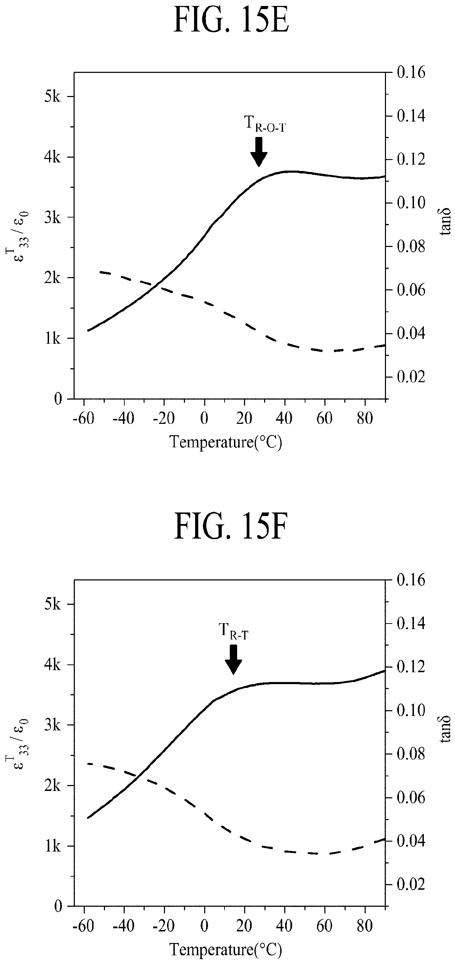

FIG. 15A shows a variation of a dielectric constant value based on a temperature of a matrix material according to an embodiment of the present disclosure, and FIGs. 15B to 15F show variations of a dielectric constant and a loss factor based on an increase in a BAZ content of the matrix material according to an embodiment of the present disclosure. In FIGs. 15A to 15F, a matrix material including a composition having the following formula: $0.96(Na_{0.5}K_{0.5})(Nb_{0.93}Sb_{0.07})O_3$-$(0.04\text{-}x)CaZrO_3$-$x(Bi_{0.5}Ag_{0.5})ZrO_3$ was prepared, and $Fe_2O_3$ of 0.5 mol% was added for sinterability.

Referring to FIGs. 15A to 15F, it may be seen that a phase temperature $T_c$ is not largely changed over a total composition at about 178 °C based on the amount of BAZ, rhombohedral (R)-orthorhombic (O) phase transition temperature $T_{R\text{-}O}$ is almost constant, and as checked in a diffraction pattern, it is shown that a rhombohedral (R) phase and an orthorhombic (O) phase coexist at a room temperature in a composition of $0.96(NaK)(NbSb)O_3$-$(0.04\text{-}x)CaZrO_3$ to which BAZ is not added. Also, orthorhombic (O)-tetragonal (T) phase transition temperature $T_{O\text{-}T}$ falls progressively as a content of BAZ increases, a ratio of three crystal structures is a ratio of about 3:3:3 in a composition of x=0.03, and a structure is provided where a rhombohedral (R) phase and a tetragonal (T) phase coexist in a composition of x=0.04 without phase transition to an orthorhombic (O) phase.

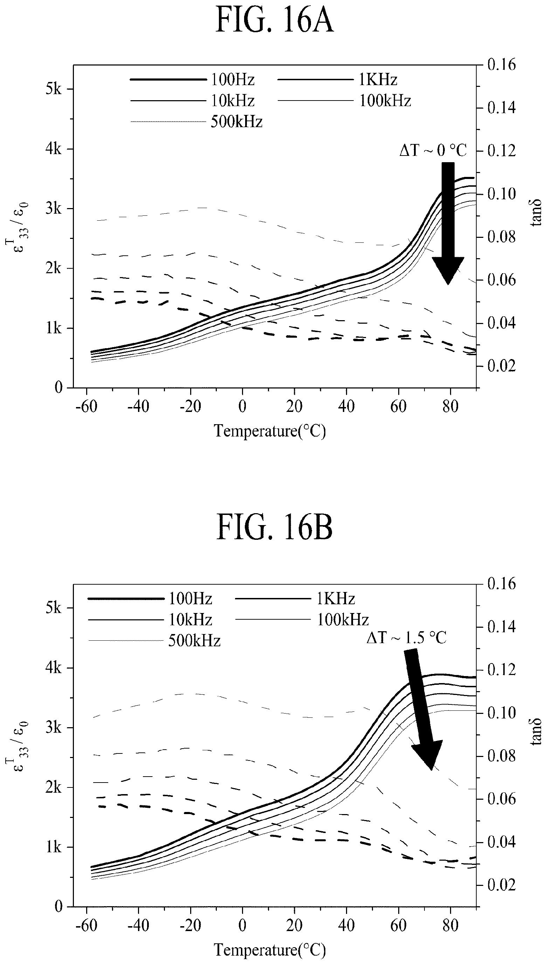

FIGs. 16A to 16E are temperature dielectric constant graphs based on different frequencies with respect to an increase in a BAZ content of a matrix material according to an embodiment of the present disclosure. In FIGs. 16A to 16E, a matrix material including a composition having the following formula: $0.96(Na_{0.5}K_{0.5})(Nb_{0.93}Sb_{0.07})O_3$-(0.04-x)$CaZrO_3$-x$(Bi_{0.5}Ag_{0.5})ZrO_3$ was prepared, and $Fe_2O_3$ of 0.5 mol% was added for sinterability.

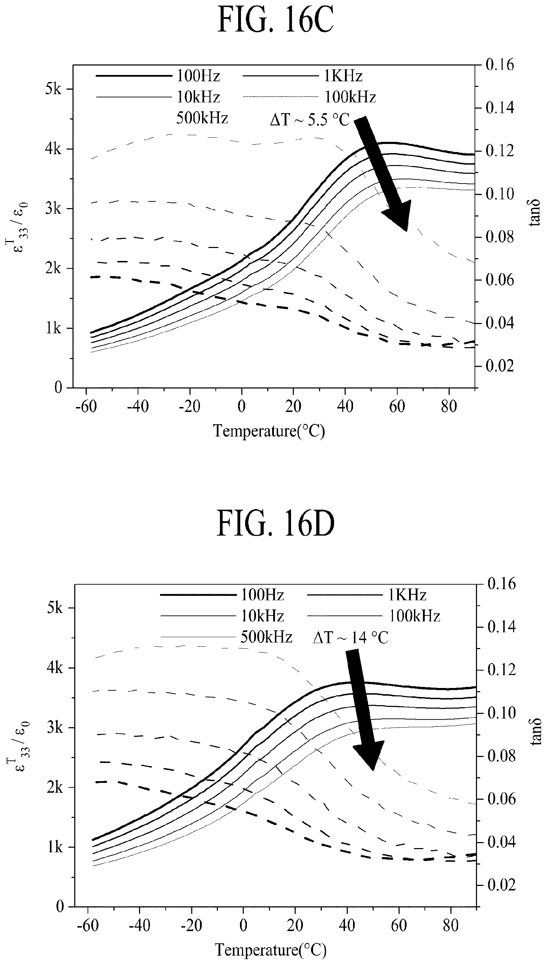

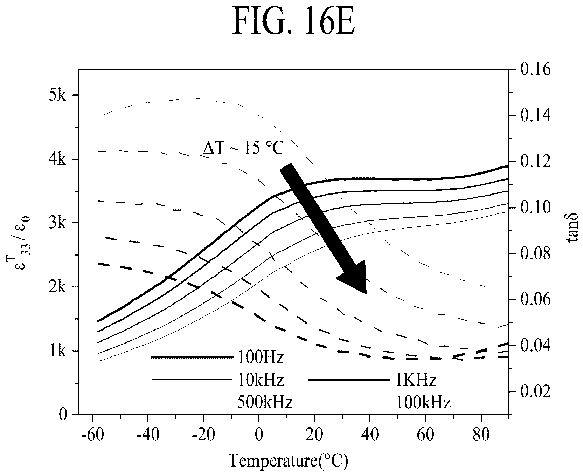

Referring to FIG. 16A, it may be seen that a temperature of a $T_{O-T}$ dielectric peak is constant despite a variation of a frequency. Referring to FIGs. 16B to 16E, it may be seen that a relaxor dielectric body having a nano domain or polar nano regions (PNR) is provided, or a dielectric peak is changed based on a frequency by a defect dipole. For example, it may be seen in FIG. 16B that a $T_{O-T}$ dielectric peak is shifted by about 1.5 °C with respect to 100 Hz to 500 kHz, it may be seen in FIG. 16C that a $T_{O-T}$ dielectric peak is shifted by about 5.5 °C with respect to 100 Hz to 500 kHz, it may be seen in FIG. 16D that a $T_{O-T}$ dielectric peak is shifted by about 14 °C with respect to 100 Hz to 500 kHz, and it may be seen in FIG. 16E that a $T_{O-T}$ dielectric peak is shifted by about 15 °C with respect to 100 Hz to 500 kHz, but embodiments of the present disclosure are not limited thereto.

Accordingly, it may be seen that the matrix material according to some embodiments of the present disclosure has a nano domain by adding a composition of BAZ because having frequency dependence.

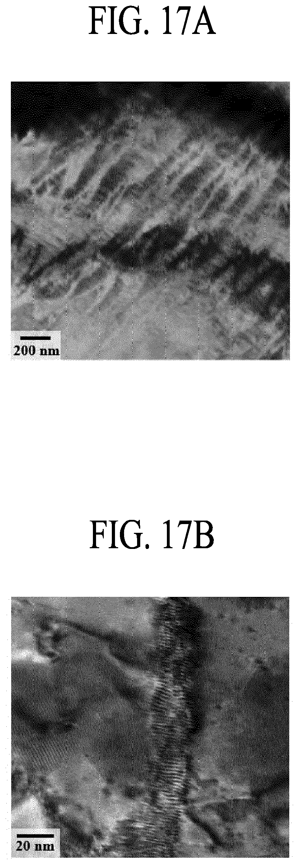

FIGs. 17A and 17B are transmission electron microphotographs of a matrix material according to an embodiment of the present disclosure. In FIGs. 17A and 17B, a matrix material including a composition having the following formula: $0.96(Na_{0.5}K_{0.5})(Nb_{0.93}Sb_{0.07})O_3$-(0.04-x)$CaZrO_3$-x$(Bi_{0.5}Ag_{0.5})ZrO_3$ was prepared, and $Fe_2O_3$ of 0.5 mol% was added for sinterability. It has been prepared that FIG. 17A is set to x=0 and FIG. 17B is set to x=0.03, and then, photographing was performed.

Referring to FIGs. 17A and 17B, it has been confirmed that a composition of x=0 shows a domain size of about 100 nm and a composition of x=0.03 shows a nano domain structure of about 3×20 nm.

Referring to FIGs. 17A and 17B in conjunction with FIG. 16, a phenomenon where frequency dependence is shown in a dielectric characteristic may be caused by the formation of a nano domain or a polar nano region (PNR).

Therefore, it may be seen that a nano domain or a polar nano region (PNR) having a nano size is formed by adding BAZ and a frequency dispersion characteristic is shown.

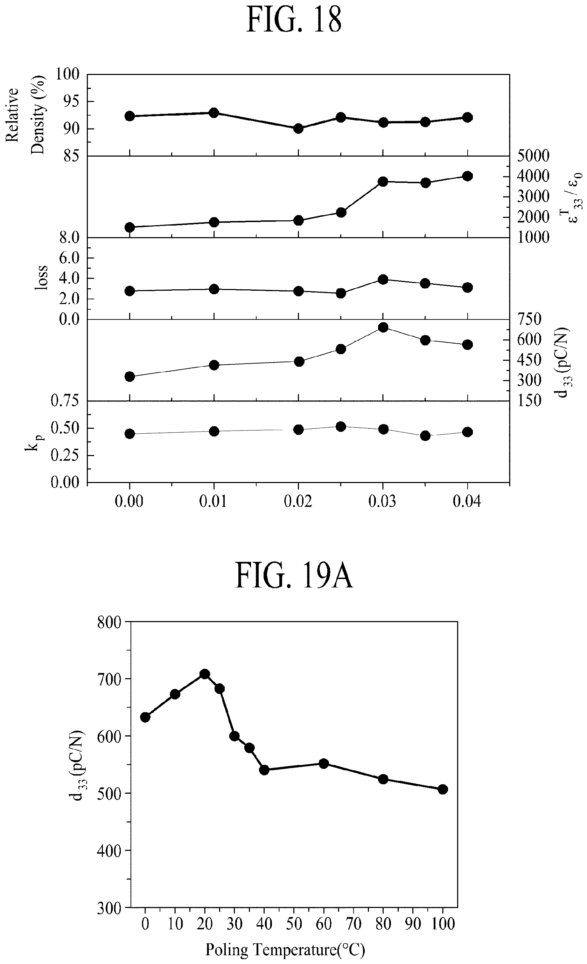

FIG. 18 illustrates a loss factor, a relative density, a dielectric constant $\varepsilon^T_{33}/\varepsilon_0$, a piezoelectric charge constant $d_{33}$, and an electromechanical coupling factor $k_\rho$ of a matrix material according to an embodiment of the present disclosure. In FIG. 18, a matrix material comprising a composition having the following formula: $0.96(Na_{0.5}K_{0.5})(Nb_{0.93}Sb_{0.07})O_3$-(0.04-x)$CaZrO_3$-x$(Bi_{0.5}Ag_{0.5})ZrO_3$ was prepared through sintering performed for 3 hours at 1,090 °C. For example, a sintering temperature may be 1,000 °C to 1,150 °C, and a maintenance time may be 1 hour to 10 hours, but embodiments of the present disclosure are not limited thereto.

Referring to FIG. 18, it may be seen that a relative density is about 92% or more when a content of BAZ is 0.00 to 0.04, and it may be seen that a dielectric constant and a piezoelectric constant increase progressively as a content of BAZ increases. It may be seen that a loss factor have a value of 4% or less when a content of BAZ is 0.00 to 0.04. It may be seen that a piezoelectric constant shows a best piezoelectric characteristic of $d_{33}$ = 710 pC/N in a composition of x=0.03 where three crystal structures such as rhombohedral (R)-orthorhombic (O)-tetragonal (T) crystal structures are provided at a similar ratio, and a piezoelectric characteristic decreases up to $d_{33}$ = 565 pC/N in a composition of x=0.04 because tetragonal (T) phases increase as a ratio increases. An electromechanical coupling factor $k_\rho$ may have a factor value for changing a stress, transferred to a material, to an electric charge, and when the factor value is 1, the change efficiency of 100% may be realized. It may be seen that a value of about 0.40 or more is shown within a range where a content of BAZ is 0.00 to 0.04.

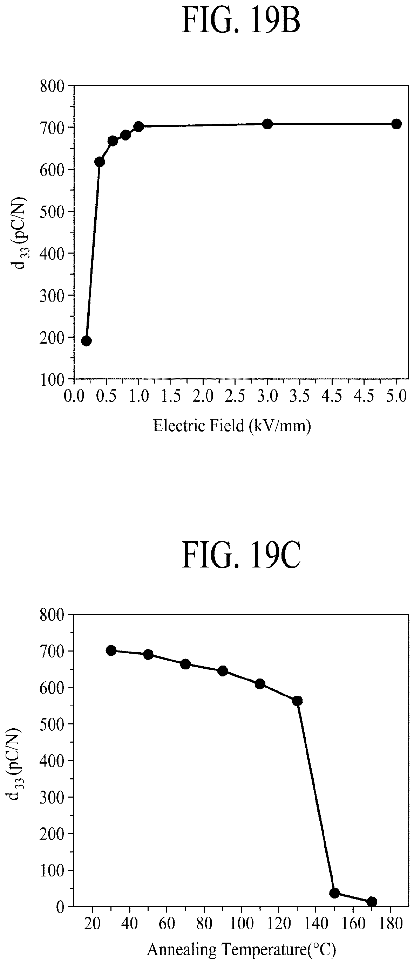

FIG. 19A is a piezoelectric charge constant based on a poling temperature of a matrix material, FIG. 19B is a piezoelectric charge constant based on an electric field, and FIG. 19C is a piezoelectric charge constant based on an annealing temperature. In FIGs. 19A to 19C, a matrix material including a composition having the following formula: $0.96(Na_{0.5}K_{0.5})(Nb_{0.93}Sb_{0.07})O_3$-0.01$CaZrO_3$-0.03$(Bi_{0.5}Ag_{0.5})ZrO_3$ was prepared.

Referring to FIG. 19A, it may be seen that a composition of x=0.03 has a best piezoelectric constant value at a poling temperature or about 20 °C because having three-phase (R-O-T) crystal structure at about 20 °C. Referring to FIG. 19B, it may be seen that the poling voltage is saturated in about 1 kV/mm. Referring to FIG. 19C, it may be seen that a piezoelectric charge constant decreases as an annealing temperature increases, and it has been confirmed that a piezoelectric characteristic is slightly reduced to a value of 568 pC/N in 130 °C and is rapidly reduced in 130 °C or more. This is because a temperature gets close to a ferroelectric-paraelectric phase transition region from a temperature of 150 °C or more.

FIG. 20 is a flowchart illustrating a method of manufacturing a seed of a piezoelectric material composition according to an embodiment of the present disclosure.

Referring to FIG. 20, a method of manufacturing a piezoelectric material composition according to an embodiment of the present disclosure may include step S21 of primarily weighing a seed material, step S22 of preparing a primary seed, step S23 of performing secondary weighing, and step S24 of preparing a secondary seed.

First, step S21 of primarily weighing the seed material may be a step of weighing a primary seed material based on a mole ratio to add an appropriate amount of solvent.

Here, a mole ratio of a compound to be synthesized in the primary seed may be $(Bi_{2.5}Na_{3.5})Nb_5O_{16}$. Hereinafter, therefore, the primary seed may be referred to as a "BNN seed."

For example, in step S21 of primarily weighing the seed material, sodium carbonate ($Na_2CO_3$), niobium pentoxide ($Nb_2O_5$), bismuth oxide ($Bi_2O_3$), and sodium chloride (NaCl) may be weighed based on a mole ratio of the compound which is to be synthesized and may be put into a nylon jar, and then, an appropriate amount of solvent may be added thereto. For example, the solvent may be ethanol, but embodiments of the present disclosure are not limited thereto.

Moreover, in the primary weighing step, a ratio of $Na_2CO_3$, $Nb_2O_5$, $Bi_2O_3$, and NaCl may be adjusted. For example, a ratio may be a weight ratio or molar ratio. For example, a ratio of NaCl to oxide including $Na_2CO_3$, $Nb_2O_5$, and $Bi_2O_3$ may be 1:1.5, but embodiments of the present disclosure are not limited thereto.

Step S22 of preparing the primary seed may further include a step of mixing materials which are weighed in a previous step and a step of phase-synthesizing mixed primary seed materials.

For example, the mixed primary seed material may be mixed with a solvent and may be mixed and milled for 12 hours by using a ball milling process. Also, the step of mixing the primary seeds may further include a drying step of separating a powder mixed with the solvent after the mixing and milling step. Here, the drying step may put the primarily mixed matrix material into a dish and may sufficiently dry the mixed matrix material at a temperature of 100 °C, but embodiments of the present disclosure are not limited thereto.

For example, the phase-synthesizing step may be a step of finely grinding a compound with a mortar after mixing and drying the primary seed material, putting the grinded compound into an alumina crucible, increasing a temperature of the grinded compound in an electric furnace at a temperature increasing speed of 5 °C/min, calcining the compound for 6 hours at 1,100 °C to 1,175 °C, and naturally cooling the calcined compound at a room temperature. A calcination-completed BNN seed may have a plate-shaped particle. Here, the step of phase-synthesizing the primary seed material may be referred to as primary calcination.

Step S22 of preparing the primary seed may further include a step of cleaning a calcination-completed primary seed.

For example, step S22 of preparing the primary seed may clean and filter the primary seed five to ten times by using water of 80 °C or more so as to remove NaCl stained on a primary seed powder, but embodiments of the present disclosure are not limited thereto.

Subsequently, the secondary weighing step S23 may be a step of putting an appropriate amount of solvent and a material including sodium (Na) for substituting the primary seed powder and bismuth (Bi) of the primary seed powder and weighing the solvent and the material based on a mole ratio of a composition.

Here, a mole ratio of a composition of the secondary seed may correspond to $NaNbO_3$. Hereinafter, therefore, the secondary seed may be referred to as an "NN seed".

For example, in the secondary weighing step, $Na_2CO_3$ and NaCl may be weighed based on a mole ratio of a composition which is to be synthesized and may be put into a beaker, and then, an appropriate amount of solvent may be added thereto. For example, the solvent may be ethanol, but embodiments of the present disclosure are not limited thereto.

Subsequently, the step S24 of preparing the secondary seed may include a step of mixing secondarily weighed materials and performing a topochemical reaction.

For example, the step of mixing the secondarily weighed materials may be performed through a stirring process and may be performed for 6 hours with 80 rpm in a state where a magnetic bar is put into a beaker, but embodiments of the present disclosure are not limited thereto.

Moreover, the step of preparing the secondary seed may further include a step of drying a mixed secondarily weighed material. Here, the drying step may put a compound into a dish and may dry the compound for 3 hours at a temperature of 100 °C.

For example, the step of performing the topochemical reaction may put a dried secondary seed material into a crucible and may be performed for 6 hours at 975 °C, but embodiments of the present disclosure are not limited thereto. By performing the topochemical reaction, Bi included in the primary seed may be replaced with Na. The topochemical reaction will be describe below in detail with reference to FIG. 21.

Here, the step of performing the topochemical reaction may be referred to as secondary calcination.

Step S24 of preparing the secondary seed may further include a step of cleaning a topochemical reaction-completed secondary seed.

For example, the step of cleaning the secondary seed may clean and filter the secondary seed five to ten times by using water of 80 °C or more so as to remove NaCl stained on an NN seed, but embodiments of the present disclosure are not limited thereto.

Moreover, even after cleaning and filtering, acid treatment may be performed with nitric acid several times so as to remove Bi remaining in the NN seed, and then, neutralization cleaning may be performed with water. For example, nitric acid may be put into a beaker, the NN seed may be put, and shaking may be performed at every 10 minutes. This may be repeatedly performed for 1 hour to 2 hours, but embodiments of the present disclosure are not limited thereto.

FIG. 21 illustrates a grain variation occurring in a step of preparing a secondary seed. A crystal structure having a composition of $Bi_2O_2[(Bi_{0.5}Na_{3.5})Nb_5O_{16}]$ illustrated in a left region of FIG. 21 shows a primary seed and may be referred to as a BNN seed. Subsequently, a crystal structure having a composition of $NaNbO_3$ illustrated in a right region of FIG. 21 shows a secondary seed and may be referred to as an NN seed.

Referring to FIG. 21, the crystal structure of the primary seed having a composition of $Bi_2O_2[(Bi_{0.5}Na0.5)Nb_5O_{16}]$ may have a layer structure having an $NbO_6$ octahedron, Na and Bi disposed between the $NbO_6$ octahedrons from an upper portion, a $(Bi_2O_2)^{2+}$ layer, a pseudo-perovskite layer, and a $(Bi_2O_2)^{2+}$ layer, wherein the layer where the $NbO_6$ octahedron and Na and Bi disposed between the $NbO_6$ octahedrons are repeated. Subsequently, a crystal structure of the secondary seed having a composition of $NaNbO_3$ may have a structure which is surrounded by Na with the $NbO_6$ octahedron therebetween.

The primary seed may be changed to the secondary seed by a topochemical reaction in step S24 of preparing the secondary seed in FIG. 21. Here, the topochemical reaction may denote a chemical reaction where an orientation of a mother grain and a grain orientation of a product has different orientation relationships but a shape of a crystal particle is maintained, in a solid-phase chemical reaction.

Therefore, as shown in FIG. 21, in a process of substituting a Bi element of the primary seed into an Na element, all layers including the layer where the $NbO_6$ octahedron and Na and Bi disposed between the $NbO_6$ octahedrons are provided, the $(Bi_2O_2)^{2+}$ layer, and the pseudo-perovskite layer, and the $(Bi_2O_2)^{2+}$ layer may be changed (or transition) to a single structure having a composition of $NaNbO_3$.

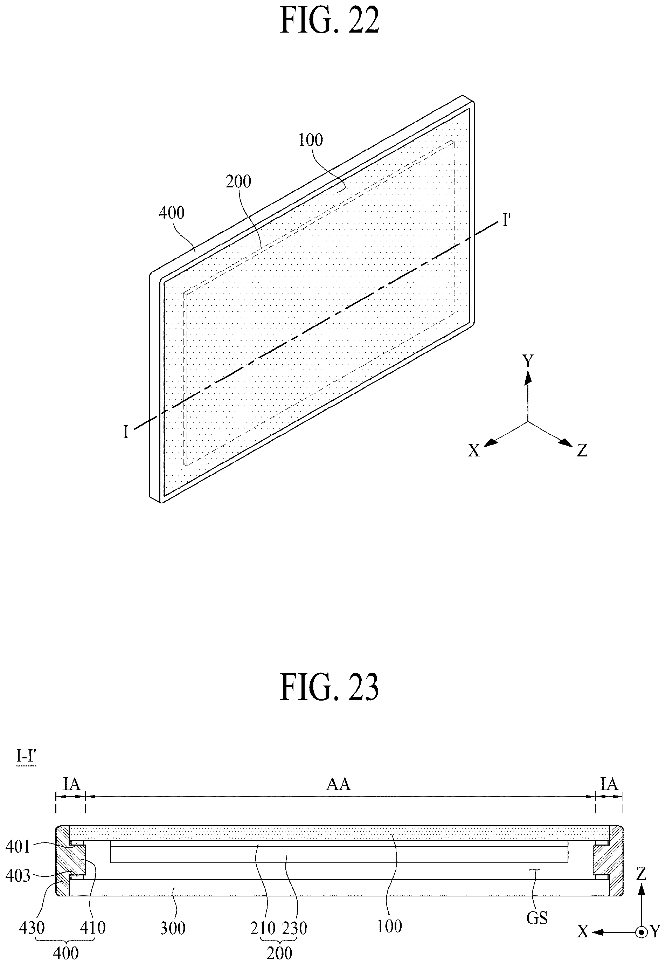

FIG. 22 is a perspective view of a display apparatus according to an embodiment of the present disclosure. FIG. 23 is a cross-sectional view taken along line I-I' of FIG. 22.

Referring to FIGs. 22 and 23, an apparatus (or a display apparatus) according to some embodiments of the present disclosure may include a vibration member (or a display panel 100) configured to display an image, and a piezoelectric device (or a vibration device) 200 disposed at a rear surface (or a backside surface) of the vibration member or the display panel 100.

The apparatus (or the display apparatus) according to some embodiments of the present disclosure may include the vibration member or the display panel 100, and the piezoelectric device (or the vibration device) 200 disposed at a rear surface (or a backside surface) of the vibration member or the display panel 100. For example, the vibration member or the display panel 100 may output a sound according to the vibration of the vibration device 200. For example, the vibration member or the display panel 100 may be a vibration object, a display panel, a vibration plate, or a front member, but embodiments of the present disclosure are not limited thereto.

For example, the vibration member or the display panel 100 or the vibration object may include one or more among a display panel including a plurality of pixels configured to display an image, a screen panel on which an image is to be projected from a display apparatus, a lighting panel, a signage panel, a vehicular interior material, a vehicular glass window, a vehicular exterior material, a building ceiling material, a building interior material, a building glass window, an aircraft interior material, an aircraft glass window, wood, plastic, glass, metal, cloth, fiber, paper, rubber, leather, carbon, and a mirror, but embodiments of the present disclosure are not limited thereto.

Hereinafter, an example where the vibration member is a display panel 100 are described.

The display panel 100 may display an electronic image or a digital image. For example, the display panel 100 may output light to display an image. The display panel 100 may be a curved display panel, or may be any type of display panel, such as a liquid crystal display panel, an organic light-emitting display panel, a quantum dot light-emitting display panel, a micro light-emitting diode display panel, and an electrophoresis display panel. The display panel 100 may be a flexible display panel. For example, the display panel 100 may a flexible light-emitting display panel, a flexible electrophoretic display panel, a flexible electro-wetting display panel, a flexible micro light-emitting diode display panel, or a flexible quantum dot light-emitting display panel, but embodiments of the present disclosure are not limited thereto.

The display panel 100 according to some embodiments of the present disclosure may include a display area AA for displaying an image according to driving of the plurality of pixels. The display panel 100 may include a non-display area IA surrounding the display area AA, but embodiment of the present disclosure is not limited thereto.

The piezoelectric device 200 may vibrate the display panel 100 at the rear surface of the display panel 100, thereby providing a sound and/or a haptic feedback based on the vibration of the display panel 100 to a user. For example, the piezoelectric device 200 may be implemented at the rear surface of the display panel 100 to directly vibrate the display panel 100, but embodiments of the present disclosure are not limited thereto.

According to some embodiments of the present disclosure, the piezoelectric device 200 may vibrate according to a voice signal synchronized with an image displayed on the display panel that is the display panel 100 to vibrate the display panel. As another embodiment of the present disclosure, the piezoelectric device 200 may vibrate according to a haptic feedback signal (or a tactile feedback signal) synchronized with a user touch applied to a touch panel (or a touch sensor layer) which is disposed at the display panel 100 or embedded into the display panel 100 and may vibrate the display panel 100. Accordingly, the display panel 100 may vibrate based on a vibration of the piezoelectric device 200 to provide a user (or a viewer) with at least one or more of a sound and a haptic feedback.

The piezoelectric device 200 according to some embodiments of the present disclosure may be implemented to have a size corresponding to the vibration member or the display panel 100 or the display area AA of the display panel 100. A size of the piezoelectric device 200 may be 0.9 to 1.1 times a size of the display area AA, but embodiments of the present disclosure are not limited thereto. For example, a size of the piezoelectric device 200 may be the same or substantially the same as or smaller than the size of the display area AA. For example, a size of the piezoelectric device 200 may be the same as or approximately same as the display area AA of the display panel, and thus, the piezoelectric device 200 may cover a most region of the display panel 100 and a vibration generated by the piezoelectric device 200 may vibrate a whole portion of the display panel 100, and thus, localization of a sound may be high, and satisfaction of a user may be improved. Also, a contact area (or panel coverage) between the display panel 100 and the piezoelectric device 200 may increase, and thus, a vibration region of the display panel 100 may increase, thereby improving a sound of a middle-low-pitched sound band generated based on a vibration of the display panel 100. Also, the piezoelectric device 200 applied to a large-sized apparatus (or a large-sized display apparatus) may vibrate the whole display panel 100 having a large size (or a large area), and thus, localization of a sound based on a vibration of the display panel 100 may be further enhanced, thereby realizing an improved sound effect. Therefore, the piezoelectric device 200 according to some embodiments of the present disclosure may be disposed at the rear surface of the display panel 100 to sufficiently vibrate the display panel 100 in a vertical direction (or front-to-rear direction), thereby outputting a desired sound to a forward region in front of the apparatus.

The piezoelectric device 200 according to some embodiments of the present disclosure may be implemented as a film-type. Since the piezoelectric device 200 may be implemented as a film-type, it may have a thickness which is thinner than the display panel 100, and thus, an increase in the thickness of the apparatus (or display apparatus) may be reduced or minimized due to the arrangement of the piezoelectric device 200. For example, the piezoelectric device 200 may be referred to as a vibration generating apparatus, a displacement apparatus, a sound apparatus, a sound generating module, a sound generating apparatus, a film actuator, a film-type piezoelectric composite actuator, a film speaker, a film-type piezoelectric speaker, a film-type piezoelectric composite speaker, or the like, but embodiments of the present disclosure are not limited thereto. As another embodiment of the present disclosure, the piezoelectric device 200 may not be disposed at the rear surface of the display panel 100 and may be applied to a vibration object instead of the display panel 100. For example, the vibration object may include one or more of wood, plastic, glass, metal, cloth, fiber, rubber, paper, leather, a vehicle interior material, a building indoor ceiling, an aircraft interior material, and the like, but embodiments of the present disclosure are not limited thereto. For example, the non-display panel may include a light-emitting diode lighting panel (or device), an organic light-emitting lighting panel (or device), or an inorganic light-emitting lighting panel (or device), and the like, but embodiments of the present disclosure are not limited thereto. In this case, the vibration object may be applied as a vibration plate, and the piezoelectric device 200 may vibrate the vibration object to output a sound.

The piezoelectric device 200 according to some embodiments of the present disclosure may further include a vibration structure 230 and a connection member 210 between the display panel 100 and the vibration structure 230.

The connection member 210 according to some embodiments of the present disclosure may include at least one substrate, and may include an adhesive layer attached to one or both surfaces of the substrate, or may be configured as a single adhesive layer.

For example, the connection member 210 may include a foam pad, a double-sided tape, an adhesive, or the like, but embodiments of the present disclosure are not limited thereto. For example, the adhesive layer of the connection member 210 may include epoxy, acrylic, silicone, or urethane, but embodiments of the present disclosure are not limited thereto.

The apparatus (or display apparatus) according to some embodiments of the present disclosure may further include a supporting member 300 disposed at a rear surface of the display panel 100.

The supporting member 300 may cover a rear surface of the display panel 100. For example, the supporting member 300 may cover a whole rear surface of the display panel 100 with a gap space GS therebetween. For example, the supporting member 300 may include at least one or more of a glass material, a metal material, and a plastic material. For example, the supporting member 300 may be a rear surface structure or a set structure. For example, the supporting member 300 may be referred to as the other term such as a cover bottom, a plate bottom, a back cover, a base frame, a metal frame, a metal chassis, a chassis base, m-chassis, or the like. For example, the supporting member 300 may be implemented as an arbitrary type frame or a plate-shaped structure disposed at a rear surface of the display panel. But embodiments of the present disclosure are not limited thereto.

The apparatus (or display apparatus) according to some embodiments of the present disclosure may further include a middle frame 400.

The middle frame 400 may be disposed between a rear periphery of the display panel 100 and a front periphery of the supporting member 300. The middle frame 400 may support one or more of the rear periphery of the display panel 100 and the front periphery of the supporting member 300, and may surround one or more of side surfaces of each of the display panel and the supporting member 300. The middle frame 400 may provide a gap space GS between the display panel and the supporting member 300. The middle frame 400 may be referred to as a middle cabinet, a middle cover, or a middle chassis, or the like, but embodiments of the present disclosure are not limited thereto.

The middle frame 400 according to some embodiments of the present disclosure may include a first supporting portion 410 and a second supporting portion 430.

The first supporting portion 410 may be disposed between the rear periphery of the display panel 100 and the front periphery of the supporting member 300, and thus, may provide a gap space GS between the display panel 100 and the supporting member 300. A front surface of the first supporting portion 410 may be coupled or connected to the rear periphery of the vibration member or the display panel 100 by a first frame connection member 401. A rear surface of the first supporting portion 410 may be coupled or connected to the front periphery of the supporting member 300 by a second frame connection member 403. For example, the first supporting portion 410 may have a single picture frame structure having a square shape or a frame structure having a plurality of divided bar shapes, but embodiments of the present disclosure are not limited thereto.

The second supporting portion 430 may be vertically coupled to an outer surface of the first supporting portion 410 in parallel with a thickness direction Z of the apparatus (or display apparatus). The second supporting portion 430 may surround one or more of an outer surface of the display panel 100 and an outer surface of the supporting member 300, thereby protecting the outer surface of each of the display panel 100 and the supporting member 300. The first supporting portion 410 may protrude from an inner surface of the second supporting portion 430 toward the gap space GS between the display panel 100 and the supporting member 300.

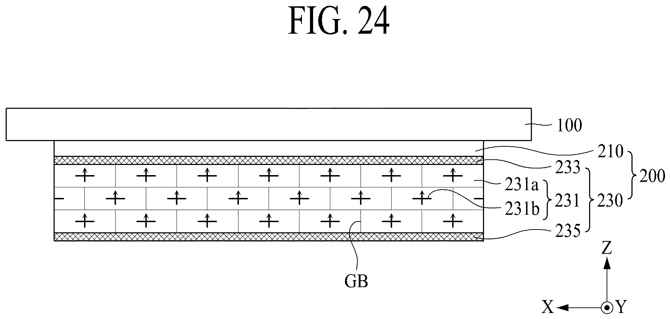

FIG. 24 illustrates a piezoelectric device of FIG. 23.

Referring to FIG. 24, a piezoelectric device 200 according to some embodiments of the present disclosure may include a vibration structure 230, and the vibration structure 230 may include a piezoelectric device layer 231, a first electrode portion 233 disposed on a first surface of the piezoelectric device layer 231, and a second electrode portion 235 disposed on a second surface opposite to the first surface.

The piezoelectric device layer 231 may include a first material layer 231a and a second material layer 231b surrounded by the first material layer 231a. According to an embodiment of the present disclosure, one first material layer 231a and one second material layer 231b may configure one grain having the same or substantially the same crystal direction, and a grain boundary GB may be formed at a portion where another first material layer 231a and second material layer 231b configuring another adjacent grain contact each other. In some embodiments, the crystal direction is +Z axis direction defined in the figures. However, the crystal direction could also be various directions applicable.

According to some embodiments of the present disclosure, a grain of the first material layer 231a may be grown based on a crystal direction of the second material layer 231b, and thus, a plurality of first material layers 231a may have the same or substantially the same crystal direction, and for example, may have a (001) crystal direction, but embodiments of the present disclosure are not limited thereto.

The first electrode portion 233 and the second electrode portion 235 may use a metal electrode, and for example, a silver electrode may be used, but embodiments of the present disclosure are not limited thereto.

Moreover, in FIG. 24, the vibration structure 230 is illustrated as a single layer, but may be configured to be additionally stacked based on the desired performance of a piezoelectric device.

It is to be understood that the foregoing embodiments of the vibration structure are exemplary and explanatory. A vibration structure according to example embodiments of the present disclosure is not limited a particular structure or constitution, such as the quantity and/or position of material layer.

A vibration apparatus according to some embodiments of the present disclosure may be applied to a vibration apparatus disposed in an apparatus. The apparatus according to some embodiments of the present disclosure may be applied to mobile apparatuses, video phones, smart watches, watch phones, wearable apparatuses, foldable apparatuses, rollable apparatuses, bendable apparatuses, flexible apparatuses, curved apparatuses, sliding apparatuses, variable apparatuses, electronic organizers, electronic book, portable multimedia players (PMPs), personal digital assistants (PDAs), MP3 players, mobile medical devices, desktop personal computers (PCs), laptop PCs, netbook computers, workstations, navigation apparatuses, automotive navigation apparatuses, automotive display apparatuses, automotive apparatuses, theater apparatuses, theater display apparatuses, TVs, wall paper display apparatuses, signage apparatuses, game apparatuses, notebook computers, monitors, cameras, camcorders, home appliances, and so on. Addition, the vibration apparatus according to some embodiments of the present disclosure may be applied to organic light-emitting lighting apparatuses or inorganic light-emitting lighting apparatuses. When the vibration apparatus of some embodiments of the present disclosure is applied to lighting apparatuses, the lighting apparatuses may act as lighting and a speaker. Addition, when the vibration apparatus of some embodiments of the present disclosure is applied to a mobile device, and so on, the vibration apparatus may act as one or more of a speaker, a receiver, and a haptic device, but embodiments of the present disclosure are not limited thereto.

A piezoelectric material composition, a method of manufacturing the same, a piezoelectric device, and apparatus including the piezoelectric device according to some embodiments of the present disclosure will be described below.

According to some embodiments of the present disclosure, a piezoelectric material composition may be represented by Formula 1:

$$\text{1 Formula 1} \quad 0.96(Na_aK_{1-a})(Nb_b(T_{1-b}))O_3-(0.04-x)MZrO_3-x(Bi_cAg_{1-c})ZrO_3 + d \text{ mol}\% \text{ NaNbO}_3$$

where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

According to one or more embodiments of the present disclosure, the piezoelectric material composition may comprise a first material and a second material surrounded by the first material.

According to one or more embodiments of the present disclosure, the first material may be represented by Formula 2:

$$\text{Formula 2} \quad 0.96(Na_aK_{1-a})(Nb_b(T_{1-b}))O_3-(0.04-x)MZrO_3-x(Bi_cAg_{1-c})ZrO_3$$

where T is Sb or Ta, M is Sr, Ba or Ca, $0.4 \leq a \leq 0.6$, $0.90 \leq b \leq 0.98$, $0.4 \leq c \leq 0.6$, and $0 \leq x \leq 0.04$.

According to one or more embodiments of the present disclosure, an aspect ratio of the first material may be 5 to 20.

According to one or more embodiments of the present disclosure, the second material may comprise $NaNbO_3$.

According to one or more embodiments of the present disclosure the piezoelectric material composition may comprise 0 mol% to 5 mol% of the second material.

According to one or more embodiments of the present disclosure, the piezoelectric material composition may comprise 3 mol% of the second material.

According to one or more embodiments of the present disclosure, the first material may comprise a plurality of grain boundary crystal-aligned in a (001) single direction, and the second material may be disposed in the plurality of grain boundary, and the plurality of grain boundary may grow through a reaction from the second material.

According to one or more embodiments of the present disclosure, the second material may be disposed at a center portion of each of the plurality of grain boundary.

According to one or more embodiments of the present disclosure, a lotgering factor of the piezoelectric material composition may be 94% or more.

According to one or more embodiments of the present disclosure, at least two phases of a tetragonal (T) phase, an orthorhombic (O) phase, or a rhombohedral (R) phase may coexist in the piezoelectric material composition at a room temperature.

According to one or more embodiments of the present disclosure, the piezoelectric material composition may comprise a nano domain.

According to one or more embodiments of the present disclosure, the piezoelectric material composition may comprise a polar nano region.

Another aspect of the present disclosure is the method of manufacturing a piezoelectric material composition, and the method may comprise mixing a matrix material with a seed material to prepare a slurry, molding the slurry to prepare a molding element, and sintering the molding element to prepare a sintered material. The matrix material and the seed material may be represented by Formula 1:

$$\text{Formula 1} \quad 0.96(Na_aK_{1-a})(Nb_b(T_{1-b}))O_3-(0.04-x)MZrO_3-x(Bi_cAg_{1-c})ZrO_3 + d \text{ mol}\% \text{ NaNbO}_3$$

In Formula 1, T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

According to one or more embodiments of the present disclosure, the matrix material may be represented by Formula 2:

$$\text{Formula 2} \quad 0.96(Na_aK_{1-a})(Nb_b(T_{1-b}))O_3 - (0.04-x)MZrO_3 - x(Bi_cAg_{1-c})ZrO_3$$

In Formula 2, T may be Sb or Ta, M may be Sr, Ba or Ca, $0.4 \leq a \leq 0.6$, $0.90 \leq b \leq 0.98$, $0.4 \leq c \leq 0.6$, and $0 \leq x \leq 0.04$.

According to one or more embodiments of the present disclosure, the seed material may comprise a $NaNbO_3$ single crystal.

According to one or more embodiments of the present disclosure, the piezoelectric material composition may comprise 0 mol% to 5 mol% of the seed material.

According to one or more embodiments of the present disclosure, the piezoelectric material composition may comprise 3 mol% of the seed material.

According to one or more embodiments of the present disclosure, in the sintering the molding element, the molding element may be maintained for 3 hours to 6 hours at 1,070 °C to 1,110 °C.

According to one or more embodiments of the present disclosure, the matrix material may be prepared by: mixing and synthesizing raw materials for manufacturing the matrix material, and milling the synthesized matrix material.

According to one or more embodiments of the present disclosure, the seed material may be prepared by: primarily weighing the seed material, preparing a primary seed, secondarily weighing the primary seed, and preparing a secondary seed, and the primary seed may include $(Bi_{2.5}Na_{3.5})Nb_5O_{16}$, and the secondary seed may include $NaNbO_3$.

According to one or more embodiments of the present disclosure, preparing the secondary seed may include a topochemical reaction performed on a compound where the primary seed, sodium carbonate ($Na_2CO_3$), and sodium chloride (NaCl) may be weighed.

According to one or more embodiments of the present disclosure, the matrix material may comprise iron oxide ($Fe_2O_3$), and the piezoelectric material composition may comprise 5 mol% of a $NaNbO_3$ seed.

In another aspect of the present disclosure, a piezoelectric device comprising a piezoelectric material layer, the piezoelectric material layer may comprise a plurality of grains, each of which including a piezoelectric material composition having a first material and a second material. The piezoelectric material composition is represented by Formula 1:

Formula 1      $0.96(Na_aK_{1-a})(Nb_b(T_{1-b}))O_3$ - $(0.04-x)MZrO_3$ - $x(Bi_cAg_{1-c})ZrO_3$ + $d$ mol% $NaNbO_3$

where T may be Sb or Ta, M may be Sr, Ba or Ca, a may be $0.4 \leq a \leq 0.6$, b may be $0.90 \leq b \leq 0.98$, c may be $0.4 \leq c \leq 0.6$, d is $0 \leq d \leq 5.0$, and x may be $0 \leq x \leq 0.04$.

According to one or more embodiments of the present disclosure, the plurality of grains may be divided by a grain boundary, the grain boundary may be a boundary between the first materials in the plurality of grains, and the second materials may be disposed at the plurality of grain boundary.

According to one or more embodiments of the present disclosure, the first materials in the plurality of grains may have the same crystal direction

According to one or more embodiments of the present disclosure, the second material may be disposed at a center portion of each of the plurality of grain boundary.

In another aspect of the present disclosure, a piezoelectric device may comprise a piezoelectric device layer including a piezoelectric material composition comprising a first material and a second material surrounded by the first material, a first electrode portion disposed at a first surface of the piezoelectric device layer, and a second electrode portion disposed at a second surface of the piezoelectric device layer opposite to the first surface. The piezoelectric material composition is represented by Formula 1:

Formula 1      $0.96(Na_aK_{1-a})(Nb_b(T_{1-b}))O_3$-$(0.04-x)MZrO_3$-$x(Bi_cAg_{1-c})ZrO_3$ + $d$ mol% $NaNbO_3$

In Formula 1, T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

According to one or more embodiments of the present disclosure, the first material may comprise $0.96(Na_aK_{1-a})(Nb_b(T_{1-b}))O_3$ - $(0.04-x)MZrO_3$ - $x(Bi_cAg_{1-c})ZrO_3$ where T=Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

According to one or more embodiments of the present disclosure, the second material may comprise $NaNbO_3$.

According to one or more embodiments of the present disclosure, the piezoelectric material composition may comprise 0 mol% to 5 mol% of the second material.

According to one or more embodiments of the present disclosure, the first material may comprise a plurality of grain boundary crystal-aligned in a (001) single direction, and the second material may be disposed in the plurality of grain boundary, and the plurality of grain boundary may grow through a reaction from the second material.

According to one or more embodiments of the present disclosure, a lotgering factor of the piezoelectric material composition may be 94% or more.

In another aspect of the present disclosure, a display apparatus may include a vibration member, and a piezoelectric device at a surface of the vibration member. The piezoelectric device may comprise a piezoelectric device layer including a first material and a second material surrounded by the first material, a first electrode portion disposed at a first surface of the piezoelectric device layer, and a second electrode portion disposed at a second surface of the piezoelectric device layer opposite to the first surface. The piezoelectric device layer may comprise a piezoelectric material composition represented by Formula 1.

It will be apparent to those skilled in the art that various modifications and variations can be made in the present disclosure without departing from the scope of the present disclosure. Thus, it is intended that the present disclosure covers the modifications and variations of this disclosure provided they come within the scope of the appended claims and their equivalents.

The present invention also relates to the following clauses:

1. A piezoelectric material composition represented by Formula 1,

Formula 1 $0.96(Na_aK_{1-a})(Nb_b(T_{1-b}))O_3-(0.04-x)MZrO_3-x(Bi_cAg_{1-c})ZrO_3$ + d mol% $NaNbO_3$ where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

2. The piezoelectric material composition of clause 1, wherein the piezoelectric material composition comprises:

a first material; and
a second material surrounded by the first material.

3. The piezoelectric material composition of clause 2, wherein the first material is represented by Formula 2:

1 Formula 2 $0.96(Na_aK_{1-a})(Nb_b(T_{1-b}))O_3-(0.04-x)MZrO_3-x(Bi_cAg_{1-c})ZrO_3$

where T is Sb or Ta, M is Sr, Ba or Ca, $0.4 \leq a \leq 0.6$, $0.90 \leq b \leq 0.98$, $0.4 \leq c \leq 0.6$, and $0 \leq x \leq 0.04$.

4. The piezoelectric material composition of clause 2, wherein an aspect ratio of the first material is 5 to 20.

5. The piezoelectric material composition of clause 2, wherein the second material comprises $NaNbO_3$.

6. The piezoelectric material composition of clause 2, wherein the piezoelectric material composition comprises 0 mol% to 5 mol% of the second material.

7. The piezoelectric material composition of clause 6, wherein the piezoelectric material composition comprises 3 mol% of the second material.

8. The piezoelectric material composition of clause 2, wherein the first material comprises a plurality of grain boundary crystal-aligned in a (001) single direction, and the second material is disposed in the plurality of grain boundary, and wherein the plurality of grain boundary grow through a reaction from the second material.

9. The piezoelectric material composition of clause 8, wherein the second material is disposed at a center portion of each of the plurality of grain boundary.

10. The piezoelectric material composition of clause 1, wherein a lotgering factor of the piezoelectric material composition is 94% or more.

11. The piezoelectric material composition of clause 1, wherein at least two phases of a tetragonal (T) phase, an orthorhombic (O) phase, or a rhombohedral (R) phase coexist in the piezoelectric material composition at a room temperature.

12. The piezoelectric material composition of clause 1, wherein the piezoelectric material composition comprises a nano domain.

13. The piezoelectric material composition of clause 1, wherein the piezoelectric material composition comprises a polar nano region.

14. A method of manufacturing a piezoelectric material composition, the method comprising:

mixing a matrix material with a seed material to prepare a slurry;
molding the slurry to prepare a molding element; and
sintering the molding element to prepare a sintered material,
wherein the matrix material and seed material are represented by Formula 1:

Formula 1 $0.96(Na_aK_{1-a})(Nb_b(T_{1-b}))O_3-(0.04-x)MZrO_3-x(Bi_cAg_{1-c})ZrO_3$ + d mol% $NaNbO_3$

where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

15. The method of clause 14, wherein the matrix material is represented by Formula 2:

Formula 2          $0.96(Na_aK_{1-a})(Nb_b(T_{1-b}))O_3-(0.04-x)MZrO_3-x(Bi_cAg_{1-c})ZrO_3$

where T is Sb or Ta, M is Sr, Ba or Ca, $0.4 \leq a \leq 0.6$, $0.90 \leq b \leq 0.98$, $0.4 \leq c \leq 0.6$, and $0 \leq x \leq 0.04$.

16. The method of clause 14, wherein the seed material comprises a $NaNbO_3$ single crystal.

17. The method of clause 14, wherein the piezoelectric material composition comprises 0 mol% to 5 mol% of the seed material.

18. The method of clause 17, wherein the piezoelectric material composition comprises 3 mol% of the seed material.

19. The method of clause 14, wherein, in the sintering the molding element, the molding element is maintained for 3 hours to 6 hours at 1,070 °C to 1,110 °C.

20. The method of clause 14, wherein the matrix material is prepared by:

mixing and synthesizing raw materials for manufacturing the matrix material; and
milling the synthesized matrix material.

21. The method of clause 14, wherein the seed material is prepared by:

primarily weighing the seed material;
preparing a primary seed;
secondarily weighing the primary seed; and
preparing a secondary seed, and
wherein the primary seed comprises $(Bi_{2.5}Na_{3.5})Nb_5O_{16}$, and the secondary seed comprises $NaNbO_3$.

22. The method of clause 21, wherein the step of preparing the secondary seed comprises a topochemical reaction performed on a compound where the primary seed, sodium carbonate ($Na_2CO_3$), and sodium chloride (NaCl) are weighed.

23. The method of clause 14, wherein the matrix material comprises iron oxide ($Fe_2O_3$), and the piezoelectric material composition comprises 5 mol% of a $NaNbO_3$ seed.

24. A piezoelectric device comprising a piezoelectric material layer, the piezoelectric material layer comprising:

a plurality of grains, each of which including a piezoelectric material composition having a first material and a second material,
wherein, the piezoelectric material composition comprises a piezoelectric material composition represented by Formula 1:

Formula 1          $0.96(Na_aK_{1-a})(Nb_b(T_{1-b}))O_3-(0.04-x)MZrO_3-x(Bi_cAg_{1-c})ZrO_3$ + d mol% $NaNbO_3$

where T is Sb or Ta, M is Sr, Ba or Ca, $0.4 \leq a \leq 0.6$, $0.90 \leq b \leq 0.98$,
$0.4 \leq c \leq 0.6$, $0 \leq d \leq 5.0$, and $0 \leq x \leq 0.04$.

25. The piezoelectric device of clause 24, wherein:

he plurality of grains are divided by a grain boundary;
the grain boundary is a boundary between the first materials in the plurality of grains; and
the second materials are disposed at the plurality of grain boundary.

26. The piezoelectric device of clause 25, wherein the first materials in the plurality of grains have the same crystal direction.

27. The piezoelectric device of clause 25, wherein the second material is disposed at a center portion of each of the plurality of grain boundary.

28. A piezoelectric device, comprising:

a piezoelectric device layer including a piezoelectric material composition comprising a first material and a second material surrounded by the first material;
a first electrode portion disposed at a first surface of the piezoelectric device layer; and
a second electrode portion disposed at a second surface of the piezoelectric device layer opposite to the first surface,
wherein the piezoelectric material composition is represented by Formula 1:

Formula 1 $0.96(Na_aK_{1-a})(Nb_b(T_{1-b}))O_3\text{-}(0.04\text{-}x)MZrO_3\text{-}x(Bi_cAg_{1-c})ZrO_3 + d$ mol% $NaNbO_3$

where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

29. The piezoelectric device of clause 28, wherein the second material comprises $NaNbO_3$.

30. The piezoelectric device of clause 28, wherein the piezoelectric material composition comprises 0 mol% to 5 mol% of the second material.

31. The piezoelectric device of clause 28, wherein the first material comprises a plurality of grain boundary crystal-aligned in a (001) single direction, and the second material is disposed in the plurality of grain boundary, and wherein the plurality of grain boundary grow through a reaction from the second material.

32. The piezoelectric device of clause 28, wherein a lotgering factor of the piezoelectric material composition is 94% or more.

33. A display apparatus, comprising:

a vibration member; and
a piezoelectric device of any one of clauses 24 to 32 at a surface of the vibration member.

**Claims**

1. A piezoelectric material composition represented by Formula 1,

Formula 1 $0.96(Na_aK_{1-a})(Nb_b(T_{1-b}))O_3\text{-}(0.04\text{-}x)MZrO_3\text{-}x(Bi_cAg_{1-c})ZrO_3 + d$ mol% $NaNbO_3$

where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

2. The piezoelectric material composition of claim 1, wherein the piezoelectric material composition comprises:

a first material; and
a second material surrounded by the first material.

3. The piezoelectric material composition of claim 2, wherein an aspect ratio of the first material is 5 to 20.

4. The piezoelectric material composition of claim 2 or 3, wherein the second material comprises $NaNbO_3$.

5. The piezoelectric material composition of any one of claims 2 to 4, wherein the first material comprises a plurality of grain boundary crystal-aligned in a (001) single direction, and the second material is disposed in the plurality of grain boundary, and wherein the plurality of grain boundary grow through a reaction from the second material.

6. The piezoelectric material composition of any one of claims 1 to 5, wherein a lotgering factor of the piezoelectric material composition is 94% or more.

7. The piezoelectric material composition of any one of claims 1 to 6, wherein at least two phases of a tetragonal (T) phase, an orthorhombic (O) phase, or a rhombohedral (R) phase coexist in the piezoelectric material composition at a room temperature.

8. The piezoelectric material composition of any one of claims 1 to 7, wherein the piezoelectric material composition comprises a nano domain.

9. A method of manufacturing a piezoelectric material composition, the method comprising:

mixing a matrix material with a seed material to prepare a slurry;
molding the slurry to prepare a molding element; and
sintering the molding element to prepare a sintered material,
wherein the matrix material and the seed material are represented by Formula 1:

Formula 1       $0.96(Na_aK_{1-a})(Nb_b(T_{1-b}))O_3\text{-}(0.04\text{-}x)MZrO_3\text{-}x(Bi_cAg_{1-c})ZrO_3 + d$ mol% $NaNbO_3$

where T is Sb or Ta, M is Sr, Ba or Ca, $0.4 \leq a \leq 0.6$, $0.90 \leq b \leq 0.98$, $0.4 \leq c \leq 0.6$, $0 \leq d \leq 5.0$, and $0 \leq x \leq 0.04$.

10. The method of claim 9, wherein the matrix material is represented by Formula 2:

Formula 2       $0.96(Na_aK_{1-a})(Nb_b(T_{1-b}))O_3\text{-}(0.04\text{-}x)MZrO_3\text{-}x(Bi_cAg_{1-c})ZrO_3$

where T is Sb or Ta, M is Sr, Ba or Ca, $0.4 \leq a \leq 0.6$, $0.90 \leq b \leq 0.98$, $0.4 \leq c \leq 0.6$, and $0 \leq x \leq 0.04$.

11. The method of claim 9 or 10, wherein the seed material comprises a $NaNbO_3$ single crystal.

12. The method of any one of claims 9 to 11, wherein the piezoelectric material composition comprises 0 mol% to 5 mol% of the seed material.

13. The method of any one of claims 9 to 12, wherein, in the sintering the molding element, the molding element is maintained for 3 hours to 6 hours at 1,070 °C to 1,110 °C.

14. A piezoelectric device, comprising:

a piezoelectric device layer including the piezoelectric material composition of claim 1, the piezoelectric material composition including a first material and a second material surrounded by the first material;
a first electrode portion disposed at a first surface of the piezoelectric device layer; and
a second electrode portion disposed at a second surface of the piezoelectric device layer opposite to the first surface,

15. A display apparatus, comprising:

a vibration member; and
a piezoelectric device of any one of claim 14 at a surface of the vibration member.

# FIG. 1

S100

```
   ┌──────────┐      ┌──────────┐
   │   S10    │      │   S20    │
   └────┬─────┘      └────┬─────┘
        │                 │
        ▼                 ▼
   ┌─────────────────────────────┐
   │         WEIGHING            │──── S101
   └──────────────┬──────────────┘
                  │
                  ▼
   ┌─────────────────────────────┐
   │          MIXING             │──── S102
   └──────────────┬──────────────┘
                  │
                  ▼
   ┌─────────────────────────────┐
   │         MOLDING             │──── S103
   └──────────────┬──────────────┘
                  │
                  ▼
   ┌─────────────────────────────┐
   │        SINTERING            │──── S104
   └──────────────┬──────────────┘
                  │
                  ▼
   ┌─────────────────────────────┐
   │     FORMING ELECTRODE       │──── S105
   └─────────────────────────────┘
```

# FIG. 2

10

13                    (001) crystal direction

13   GB   11                12

# FIG. 3

K, Na, Sr    Nb, Sb, Zr    O

# FIG. 4A

# FIG. 4B

# FIG. 4C

# FIG. 5

# FIG. 6A

# FIG. 6B

Domain size (nm)

# FIG. 7

$NaNbO_3$ seed contents (mol %)

# FIG. 8

# FIG. 9

# FIG. 10

# FIG. 11

S10

| WEIGHING | — S11 |
| MIXING | — S12 |
| CALCININATION | — S13 |
| MILLING | — S14 |
| MOLDING | — S15 |
| SINTERING | — S16 |
| FORMING ELECTRODE | — S17 |

# FIG. 12

# FIG. 13A

# FIG. 13B

# FIG. 13C

# FIG. 13D

# FIG. 13E

# FIG. 14

# FIG. 15A

# FIG. 15B

# FIG. 15C

# FIG. 15D

# FIG. 15E

# FIG. 15F

# FIG. 16A

# FIG. 16B

## FIG. 16C

## FIG. 16D

# FIG. 16E

# FIG. 17A

# FIG. 17B

# FIG. 18

# FIG. 19A

# FIG. 19B

# FIG. 19C

# FIG. 20

S20

| | |
|---|---|
| PRIMARY WEIGHING | ~ S21 |
| PREPARING PRIMARY SEED MATERIAL | ~ S22 |
| SECONDARY WEIGHING | ~ S23 |
| PREPARING SECONDARY SEED MATERIAL | ~ S24 |

# FIG. 21

$(Bi_2O_2)^{2+}$ layer

Pseudo-perovskite layer

$(Bi_2O_2)^{2+}$ layer

$Bi_2O_2[(Bi_{0.5}Na_{3.5})Nb_5O_{16}]$

$NbO_6$ Octahedron

Na ⟳ Bi

Topochemical reaction

Na
Bi
O

$NaNbO_3$

# FIG. 22

# FIG. 23

I-I'

# FIG. 24

Europäisches
Patentamt

European
Patent Office

Office européen
des brevets

# EUROPEAN SEARCH REPORT

Application Number

EP 22 21 4442

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GO SU-HWAN ET AL: "Piezoelectricity of (K,Na)(Nb,Sb)O 3 -SrZrO 3 (Bi,Ag)ZrO 3 piezoceramics and their application in planar-type actuators", JOURNAL OF MATERIALS CHEMISTRY C, vol. 9, no. 46, 1 January 2021 (2021-01-01), pages 16741-16750, XP093046478, GB ISSN: 2050-7526, DOI: 10.1039/D1TC04136C * whole document - see in particular the abstract, Experimental procedure and Conclusions * ----- | 1-15 | INV. C04B35/495 H10N30/853 |
| X | GO SU-HWAN ET AL: "Excellent piezoelectric properties of (K, Na)(Nb, Sb)O3-CaZrO3-(Bi, Ag)ZrO3 lead-free piezoceramics", JOURNAL OF ALLOYS AND COMPOUNDS, ELSEVIER SEQUOIA, LAUSANNE, CH, vol. 889, 1 September 2021 (2021-09-01), XP086842384, ISSN: 0925-8388, DOI: 10.1016/J.JALLCOM.2021.161817 [retrieved on 2021-09-01] * whole document - see in particular the abstract and 2. Experimental Prcoedures * ----- -/-- | 1-15 | TECHNICAL FIELDS SEARCHED (IPC) C04B H02N H10N |

The present search report has been drawn up for all claims

| Place of search | Date of completion of the search | Examiner |
|---|---|---|
| Munich | 15 May 2023 | Munro, Brian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

## EUROPEAN SEARCH REPORT

Application Number

EP 22 21 4442

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KIM DAE-SU ET AL: "Remarkable piezoelectric performance and good thermal stability of<001>-textured 0.96(K0.5Na0.5)(Nb1-ySby)O3-0.04SrZrO3 lead-free piezoelectric ceramics", JOURNAL OF ALLOYS AND COMPOUNDS, ELSEVIER SEQUOIA, LAUSANNE, CH, vol. 882, 7 June 2021 (2021-06-07), XP086702271, ISSN: 0925-8388, DOI: 10.1016/J.JALLCOM.2021.160662 [retrieved on 2021-06-07] * whole document - see in particular, the abstract, 2 Experimental and 4. Conclusions * | 1-15 | |
| X | WANG TING ET AL: "Enhanced piezoelectric properties in 0.96(KNa)(NbTa)O-0.04(BiAg)ZrOlead-free ceramics", JOURNAL OF MATERIALS SCIENCE: MATERIALS IN ELECTRONICS, CHAPMAN AND HALL, LONDON, GB, vol. 31, no. 12, 8 May 2020 (2020-05-08), pages 9525-9534, XP037155584, ISSN: 0957-4522, DOI: 10.1007/S10854-020-03494-5 [retrieved on 2020-05-08] | 1 | TECHNICAL FIELDS SEARCHED (IPC) |
| A | * abstract, figure 1 * | 2-15 | |

The present search report has been drawn up for all claims

| Place of search | Date of completion of the search | Examiner |
|---|---|---|
| Munich | 15 May 2023 | Munro, Brian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)